(19) **Europäisches Patentamt**

**European Patent Office**

**Office européen des brevets**

(11) **EP 1 035 419 B1**

(12) **EUROPÄISCHE PATENTSCHRIFT**

(45) Veröffentlichungstag und Bekanntmachung des Hinweises auf die Patenterteilung:
**28.07.2004 Patentblatt 2004/31**

(51) Int Cl.⁷: **G01S 13/02**

(21) Anmeldenummer: **00105988.0**

(22) Anmeldetag: **07.05.1997**

(54) **SAW-Element**

SAW element

Elément à ondes acoustiques de surface

(84) Benannte Vertragsstaaten:
**CH DE FR LI**

(30) Priorität: **07.05.1996 CH 115796**

(43) Veröffentlichungstag der Anmeldung:
**13.09.2000 Patentblatt 2000/37**

(62) Dokumentnummer(n) der früheren Anmeldung(en) nach Art. 76 EPÜ:
**97923854.0 / 0 939 907**

(73) Patentinhaber: **HERA Rotterdam B.V.**
**3062 MA Rotterdam (NL)**

(72) Erfinder:
 • **Stierlin, Roland**
 **5034 Suhr (CH)**
 • **Peter, Reto**
 **8006 Zürich (CH)**

(74) Vertreter: **VOSSIUS & PARTNER**
**Siebertstrasse 4**
**81675 München (DE)**

(56) Entgegenhaltungen:
**WO-A-93/13495**          **GB-A- 2 070 393**
**US-A- 3 883 831**        **US-A- 4 734 698**
**US-A- 4 737 790**

 • **PLESSKY ET AL.: "SAW Tags:New Ideas" 1995 IEEE ULTRASONICS SYMPOSIUM, Seiten 117-120, XP002040038**
 • **REINDL ET AL.: "Programmable Reflectors for SAW-ID-Tags" 1993 IEEE ULTRASONICS SYMPOSIUM, 31. Oktober 1993 (1993-10-31), Seiten 125-130, XP000473552**
 • **DANICKI: "A SAW Resonator Filter Exploiting RMSCs" 1994 IEEE INTERNATIONAL FREQUENCY CONTROL SYMPOSIUM, Seiten 337-342, XP000647174**

## Beschreibung

Die Erfindung betrifft ein SAW-Element mit einem piezoelektrischen Substrat, wobei mindestens ein interdigitaler Transducer (IDT) zum Einlaufenlassen einer akustischen Oberflächenwelle in einen akustischen Kanal in einer ersten Richtung auf der Oberfläche des Substrats angeordnet ist, und ein Reflektor auf derselben Oberfläche im Inneren des Kanals angeordnet und derart orientiert ist, daß er die akustische Oberflächenwelle in eine zweite Richtung, entgegengesetzt zu der ersten Richtung reflektiert.

Verfahren der eingangs genannten Art, die die Identifikation von Transpondern beschreiben, sind z.B. aus den US-Patenten 4,737,790 (Skeie et al./X-Cyte Inc.), 4,734,698 (Nysen et al. X-Cyte Inc.) und 4,096,477 (Epstein et al. Northwestern University) bekannt. Mittels einer Abfragestation werden dabei passive SAW-Transponder (sogenannte SAW-tags) identifiziert. Die Transponder verfügen über ein geeignet verpacktes SAW-Element (SAW = surface acoustic wave) aus piezoelektrischem Material und geeignete Antennen zum Empfangen und Abstrahlen von elektromagnetischen Wellen im Bereich von 905-925 MHz. Das SAW-Element modifiziert das empfangene Abfragesignal und erzeugt eine Vielzahl von Antwortsignalen mit je einer charakteristischen Laufzeit. Für die Codierung des SAW-Elementes werden zwei unterschiedliche Verfahren verwendet. Im Patent 4,096,477 wird ein SAW-Element verwendet, das keine Reflektoren enthält und auf dem durch Verwenden oder Auslassen eines Ausgangstranducers eine binäre Codierung realisiert isz. Das Antwortsignal enthält damit eine unterschiedliche, codespezifische Anzahl Signalkomponenten. Dies bedeutet beispielsweise für einen Code 1000 (binär), daß genau eine, für den Code 1111 (binär) genau 4 Antwortsignalkomponenten vorhanden sind. Als Abfragesignal wird ein kurzer Puls verwendet.

Im Verfahren, das in den Patenten von X-Cyte beschrieben ist, modifiziert das SAW-Element zusätzlich die Phasen der Antwortsignale. Die Anzahl der Antwortsignalkomponenten ist dabei unabhängig vom realisierten Code, was für die Decodierung ein Vorteil ist. Das Abfragesignal ist ein sogenanntes Chirp-Signal, dessen Frequenz sägezahnartig im Bereich von 905-925 MHz variiert. Das SAW-Element verfügt über 16 verschiedene Ausbreitungspfade (akustische Codierkanäle). Damit ergeben sich 16 verschiedene Antwortsignale, deren Signallaufzeiten für alle SAW-Elemente des Systems so festgelegt sind, daß sie sich jeweils um ein vorgegebenes Zeitintervall ΔT unterscheiden. Die über verschiedene Pfade laufenden Antwortsignale weisen somit eine konstante (d.h. für alle tags gleiche) zeitliche Stufung auf. Beim Mischen des Abfragesignals mit den Antwortsignalen wird in der Abfragestation eine vorgegebene Anzahl von im voraus bekannten Differenzfrequenzen erzeugt.

Die Differenzfrequenzsignale entsprechen den Schwebungen zwischen den Abfrage- und den zeitlich verzögerten Antwortsignalen. Sie werden von entsprechend abgestimmten Filtern verarbeitet. Da in jedem Ausbreitungspfad des SAW-Elements Dämpfungs- bzw. Phasenschiebeelemente entsprechend dem transponderspezifischen Code eingebaut sind, lassen sich aus den Phasen bzw. Amplituden der Differenzfrequenzsignale die transponderspezifischen Codeinformationen gewinnen.

Temperaturänderungen und Herstellungstoleranzen führen zu störenden Laufzeitschwankungen der Antwortsignale. Daraus ergeben sich Phasenschwankungen die eine Decodierung verfälschen, erschweren oder gar unmöglich machen. Für die praktische Anwendung wird daher ein Verfahren zur Kalibrierung angewandt wie es im erwähnten US-Patent 4,734,698 beschrieben wird. Dazu müssen zwei Codierkanäle im Transponder einen einheitlichen, transponderunspezifischen Code tragen. Die Differenz der beiden entsprechenden Antwortsignale dient als Referenz für die genauere Bestimmung der Phaseninformation der anderen Antwortsignale.

Das oben beschriebene oder ähnliche Verfahren weisen eine Reihe von nachstehend aufgeführten Problemen auf. Die verwendete Phasencodierung ist bei einer Frequenz von 2.45 GHz enorm störanfällig, da bereits kleinere Temperaturschwankungen zu großen Phasenänderungen führen. Wird z.B. Lithiumniobat (0,7 %/100°C) als Substratmaterial für das SAW-Element verwendet, so ist bei einer Temperaturänderung von 100°C und einer relativen Laufzeitdifferenz von 100 ns die relative Phasenänderung der entsprechenden Antwortsignale ca. 230° bei 905 MHz und ca. 615° bei 2,45 GHz. Bei 2,45 GHz ergeben sich Probleme mit der Mehrdeutigkeit oder aber die Reflektoren müßten so nahe beieinander sein, daß Probleme mit der Auflösung entstehen und/oder sich Probleme mit der Plazierung von für die Codierung notwendigen Phasenelementen ergeben.

Ein weiteres Problem ergibt sich aus der beschrieben Art der Kalibrierung. Die Verwendung von zwei Antwortsignalen mit einheitlicher, tranponderunspezifischer Codierung reduziert die Anzahl der für die Identifikation verwendbaren Antwortsignale um 2. In der beschrieben Ausführung von X-Cyte wird damit die Anzahl unabhängiger Codes im Vergleich zum selben System ohne Kalibrierung um den Faktor 4x4=16 reduziert.

Ein weiteres Problem ergibt sich aus der Notwendigkeit zur optimalen Trennung von Antwortsignalen und Störsignalen. Die Störsignale entstehen sowohl außerhalb des Transponders (z.B. durch Reflexionen des Abfragesignals an metallischen Gegenständen) als auch innerhalb desselben (z.B. Mehrfachreflexionen zwischen Transducer (Wandler) und Reflektoren in den akustischen Kanälen). Die störenden internen Reflexionen können bekannterweise dadurch wirksam reduziert werden, wenn im Antwortsignal die Komponente mit der längsten Laufzeit mindestens doppelt so lang ist, wie die kürzeste Laufzeit. Diese Bedingung führt aber in der bekannten Ausgestaltung des SAW-Elementes und bei großer Anzahl (z.B. > 6) an Codierkanälen zu SAW-Elementen mit hohem Chip-Flächenbedarf. Ein weiteres Problem ergibt sich aus der Forderung nach kostengünstiger Produktion des SAW-Elementes. Ein für die Stückkosten wichtiger Faktor ist dabei die Fläche des SAW-Elementes. Je kleiner diese ist, desto preiswerter wird der tag. Die bekannten SAW-tags vermögen diesbezüglich nicht zu befriedigen.

Weitere Probleme ergeben sich mit dem in der US-A-4,096,477 ausgeführten Verfahren zur Codierung der SAW-Elemente dadurch, daß die Anzahl der zu verarbeitenden Antwortsignale codespezifisch ist, die internen Störsignale (Mehrfachreflexionen zwischen den Transducern) stark und zahlreich sind und eine hohe Anzahl von Ausgangstransducern benötigt wird (z.B. für $2^{16}$ Codes werden 16 Ausgangstranducer benötigt).

Ein weiteres Problem ergibt sich daraus, die einfallenden Abfragesignale möglichst effizient, d.h. mit minimalen Verlusten in Antwortsignale umzuwandeln. Je besser die Reflektoren die Abfragesignale reflektieren, desto größer ist z.B. die maximal erreichbare Lesedistanz. Dafür geeignete Reflektoren werden z.B. in dem US-Patent 4 737 790 beschrieben. Sie arbeiten auf der Grundfrequenz von ca. 915 MHz. Die Herstellung von Reflektoren auf einer Grundfrequenz von ca. 2,45 GHz ist herstellungstechnisch sehr schwierig, da die Breite der Elektrodenfinger ca. 0,4 µm ist und bringt damit erhebliche Kostennachteile. Die Verwendung von Reflektoren, die auf der 3. Harmonischen arbeiten und eine Breite der Elektrodenfinger von ca. 0,6 µm haben ist aus der Literatur bekannt (z.B. K. Yamanouchi, "2,5 GHz-range SAW propagation....", 1993 IEEE Ultrasonics Symposium). Die genaue Breite der Elektrodenfinger hängt insbesondere ab vom verwendeten Substratmaterial. Die obigen Angaben beziehen sich auf 128°-LiNbO$_3$.

Ein weiteres Problem ergibt sich daraus, auf einer gegebenen Chipfläche die Anzahl möglicher Codes (Kostenreduktion) und gleichzeitig die Stärke der Antwortsignale (lange Lesedistanz oder sichere Auslesung in Umgebung mit starken Störsignalen) zu maximieren.

Eine wirkungsvolle Erhöhung der Antwortsignalstärke wird erreicht, wenn möglichst wenig akustische Kanäle realisiert werden müssen. Wie in der Literatur angegeben (V.P. Plessky, et al., "SAW Tags: New Ideas", 1995 IEEE Ultrasonics Symposium) ergibt sich z.B. ein Zusatzverlust von 12 dB, wenn anstelle eines Transducers mit 2 akustischen Kanälen eine Lösung mit 4 Transducer und 8 akustischen Kanälen realisiert wird.

Um bei wenigen oder gar nur einem akustischen Kanal eine Vielzahl verschiedener Codes zu erzeugen, ist es vorteilhaft, in den gleichen Kanal mehrere Reflektoren zu setzen, wie dies aus der Literatur (z.B. L. Reindl et al. "Programmable reflectors for Saw-ID-tags", 1993 IEEE Ultrasonic Symposium) bekannt ist. Bei mehr als einem Reflektor in einem Kanal entstehen Mehrfachreflexionen zwischen den Reflektoren, die insbesondere bei der Anwendung der beschriebenen Positionscodierung stören können. Der störende Einfluß kann vermindert werden, wenn z.B. die Reflektivität einer Mehrzahl von Reflektoren klein gewählt wird oder die Reflektoren weit auseinander gesetzt werden. Beides führt zu einer Abschwächung der Antwortsignale der entsprechenden Reflektoren, was für das Identifikationssystem nachteilig ist und z.B. die maximale Lesedistanz reduziert.

Aufgabe der Erfindung ist es, ein Verfahren der eingangs genannten Art anzugeben, das eine möglichst einfach realisierbare und wenig störanfällige Identifizierung erlaubt und dabei eine große Codiervielfalt (d.h. einen großen Coderaum) mit guter Nutzung der Chipfläche des SAW Elements zuläßt.

Die erfindungsgemäße Lösung ist durch die Merkmale des Anspruchs 1 definiert. Die Erfindung betrifft ein SAW-Element mit einem piezoelektrischen Substrat, wobei mindestens ein interdigitaler Transducer (IDT) zum Einlaufenlassen einer akustische Oberflächenwelle in einen akustischen Kanal in einer ersten Richtung auf der Oberfläche des Substrats angeordnet ist, und ein Reflektor auf derselben Oberfläche im Inneren des Kanals angeordnet und derart orientiert ist, daß er die akustische Oberflächenwelle in eine zweite Richtung, entgegengesetzt zu der ersten Richtung reflektiert, wobei der Reflektor quer, vorzugsweise senkrecht zu dem akustischen Kanal in mindestens zwei Bereiche, die je einen Unterkanal aufspannen, unterteilt und mindestens ein Bereich in Richtung des akustischen Kanals mit einem Versatz angeordnet ist.

Die Abfragestation verwendet vorzugsweise ein Chirpsignal zur Abfrage des Transponders. Das Antwortsignal kann als abgetastetes, digitalisiertes Zeitsignal gespeichert und zur Decodierung der identifizierenden Information einer diskreten Fouriertransformation (FFT) unterworfen werden. Im Frequenzbereich können die Laufzeitunterschiede einfacher detektiert und bearbeitet werden. Zusammen mit der erfindungsgemäßen Realisierung der SAW-Elemente wird eine wirksame Eliminierung von internen Störsignalen und eine kostengünstige Realisierung der Transponder ermöglicht.

Die Codierung führt zu einer charakteristischen, zeitlichen Verzögerung von mindestens einem Teil der Antwortsignalkomponenten. Ein wichtiges Merkmal des Verfahrens ist, daß die Anzahl der identifizierenden Signalkomponenten unabhängig vom implementierten Codewort ist. Sie ist identisch für alle Transponder einer bestimmten Anwendung. Zur Detektion eignet sich die als solche bekannte matched filter-Technik.

Genau eine Antwortsignalkomponente (kalibrierendes Antwortsignal) wird dazu verwendet, die störenden Laufzeitänderungen der Grundverzögerung TO zu messen und die Korrektur der Laufzeiten mindestens der identifizierenden Antwortsignalbestandteile durchzuführen. Ein wichtiges Merkmal des neuen Verfahrens ist, daß die temperaturbedingten relativen Laufzeitschwankungen der identifizierenden Antwortsignale untereinander vernachläßigt werden können.

Die Laufzeiten der identifizierenden Antwortsignale sind so festgelegt, daß jedes Signal in genau einem vorgegebenen Zeitfenster (bezeichnet mit A,B,C, D,...) liegt. Die Summe aller Zeitfenster bildet eine Kette sich nicht überschneidender Zeitintervalle. Jedes Zeitfenster (numeriert mit 0,1,2,3,...) ist wiederum in vordefinierte, dem System bekannte Zeitschlitze unterteilt. Erfindungsgemäß sind die Laufzeiten der identifizierenden Antwortsignale so festgelegt, daß das Signal, respektive der Energieschwerpunkt des Signals, in einen der vordefinierten Zeitschlitze (bezeichnet z.B. mit A0, d.h. im Zeitschlitz 0 von Zeitfenster A) fällt. Die Gesamtheit der besetzten Zeitschlitze bilden ein charakteristisches Muster auf der Zeitachse (bzw. im Spektrum), das der auszulesenden Codenummer entspricht.

Die Größe der verwendeten Zeitschlitze richtet sich nach der Bandbreite des Systems, insbesondere des Abfragesignals. In einer bevorzugten Ausführung ist die Bandbreite des Systems 40 MHz und die Größe der Zeitschlitze mindestens 25 ns. Die Anzahl der Zeitfenster $N_{ZF}$ (z.B. 8) ist bestimmt durch die Anzahl der Codierkanäle respektive der identifizierenden Antwortsignale. Wird die Anzahl der Zeitschlitze pro Zeitfenster mit $N_{ZS}$ (z.B. 4) angegeben, so ergibt sich die folgende Anzahl N möglicher Codes:

$$N = N_{ZS}{}^{N}ZF, \text{ (z.B. } 4^8 = 2^{16}) \qquad (1)$$

Ein wichtiger Vorteil der vorliegenden Erfindung ist es, daß mit wenigen Transducern und Reflektoren eine große Anzahl von Codes erzeugt werden kann. Bei zwei Codierkanälen mit je einem Reflektor benötigt es insgesamt 1 Transducer und 2 Reflektoren um $2^{16}$ mögliche Codes zu realisieren, wenn jeweils 16 Zeitschlitze für die beiden Zeitfenster vorgesehen werden. Im bekannten Verfahren (vgl. eingangs zitierte Patente der Firma X-Cyte) werden für die gleiche Anzahl Codes 4 Transducer und 8 Reflektoren benötigt.

Für die Kalibrierung wird in einem codierenden oder in einem separaten Kanal eine einheitliche Codierung (Familiencode) für alle Transponder einer Anwendung festgelegt. Damit liegen alle kalibrierenden Antwortsignale einer Anwendung z.B. im gleichen Zeitschlitz des gleichen Zeitfensters. Diese Position ist dem System bekannt und kann von Anwendung zu Anwendung definiert verändert werden, z.B. durch Verschieben des kalibrierenden Antwortsignals in einen anderen Zeitschlitz des gleichen Zeitfensters. Damit werden Familien von Transpondern mit gleicher Codenummer aber unterschiedlichem Familiencode definiert.

Die Bestimmung der Ist-Position der kalibrierenden Antwortsignalkomponente im Spektrum des Antwortsignals erlaubt zusammen mit dem Wissen über die Sollposition, die ungefähre Bestimmung der störenden Änderung der Grundverzögerung TO. Diese Laufzeitschwankungen entstehen durch Temperaturänderungen im Transponder, durch die sich ändernde Luftstrecke zwischen Transponder und Antenne der Abfragestation, durch die variable Länge des Antennenkabels und durch Alterung oder Temperaturänderungen in den elektrischen Leitungen zwischen Antenne und Verarbeitungseinheit der Abfragestation.

Im Unterschied zu der im Stand der Technik bekannten Kalibrierung wird beim erfindungsgemäßen Verfahren genau eine Antwortsignalkomponente zur Kalibrierung verwendet. Diese Antwortsignalkomponente ist vorzugsweise diejenige mit der kürzesten Laufzeit. Durch einen Sperrzeitschlitz vorgegebener Dauer ist sie gegenüber den identifizierenden Antwortsignalkomponenten abgetrennt.

Zur Durchführung der Kalibrierung wird mit Vorteil

- das abgetastete und gespeicherte Antwortsignal (Zeitsignal) mit einer Fensterfunktion gewichtet und anschließend einer diskreten Fouriertransformation unterworfen und
- im resultierenden Spektrum eine Ist-Position der kalibrierenden Antwortsignalkomponente bestimmt und mit einer vorgegebenen Soll-Position verglichen.

Die Soll-Ist-Abweichung führt zu einer Frequenzverschiebung $\Delta\omega$, die zur Kalibrierung des Zeitsignals verwendet werden kann.

- Das Zeitsignal wird mit einer Funktion $f(t) = e^{-j\Delta wt}$ multipliziert, was zur Schiebung des Spektrums in eine dem FFT-Raster angepaßte Position führt und als kalibriertes Zeitsignal gespeichert.
- Das Resultat der Multiplikation wird mit einer geeigneten Fensterfunktion gewichtet und einer neuen diskreten Fouriertransformation unterworfen.
- Im erhaltenen Spektrum werden die Maxima der Stützwerte in einer Vielzahl der oder in allen Frequenzfenstern bestimmt. Anschließend wird geprüft, ob die erhaltenen maximalen Stützwerte einen genügenden Rauschabstand aufweisen. Wenn ja, wird der entsprechende Code bestimmt. Wenn nein, wird die Auswertung abgebrochen.

Um auch bei langen Codes und starken Temperatureinflüssen eine zuverlässige Bestimmung des Codes zu ermöglichen, kann das Antwortsignal in mehrere Blöcke aufgeteilt werden. Diese Blöcke werden sukzessive abgearbeitet, wobei in jedem Block eine temperaturbedingte Laufzeit- bzw. Frequenzverschiebung kompensiert wird und dann die entsprechenden identifizierenden Antwortsignalkomponenten ausgewertet werden.

Um Temperatureinflüsse u. dgl. bei der Bestimmung des in den identifizierenden Anwortsignalkomponenten enthaltenen Codes weiter zu minimieren, kann eine zusätzliche, rein rechnerische Korrektur erfolgen. Dazu wird aus dem Spektrum des kalibrierten Zeitsignals durch Korrelation der Position aller dem kalibrierenden Stützwert genügend nahen Stützwerte mit deren Soll-Positionen eine temperaturbedingte Frequenzverschiebung $\delta\Delta\omega$ bestimmt. ("Genügend nahe" bedeutet, daß die maximal zu erwartenden Störeinflüsse in keinem Fall eine wesentliche Verschiebung der in diesem ersten Block berücksichtigten Stützwerte herbeiführen können.) Anschließend wird das gespeicherte und kalibrierte Zeitsignal mit einer Funktion $f(t) = e^{-j\delta\Delta\omega t}$ multipliziert, mit einer Fensterfunktion geeignet gewichtet und fouriertransformiert. Das resultierende Spektrum wird in dieser Weise sukzessive abgearbeitet, wobei jeweils in einer geeigneten Anzahl von noch nicht decodierten Frequenzfenstern die maximalen Stützwerte bestimmt und daraufhin geprüft werden, ob sie einen genügenden Rauschabstand aufweisen, bevor der dazugehörige Teil des Codes bestimmt wird.

In einer weiteren Ausführungsform der Erfindung wird ein Transponder so realisiert, daß nebst identifizierenden und kalibrierenden auch messende Antwortsignalkomponenten an die Abfragestation übertragen werden. Damit können individuell adressierte und berührungslos ausgelesene Meßsonden realisiert werden. Insbesondere der für die Identifikation störende Effekt der Temperaturabhängigkeit der Signalverzögerung kann gezielt zur Temperaturmessung verwendet werden. Die kalibrierenden Antwortsignale können dabei eine Doppelfunktion übernehmen und dienen der Kalibrierung von identifizierenden und messenden Antwortsignalen.

Zur Durchführung einer solchen Messung werden vom SAW-Element mindestens zwei Antwortsignalkomponenten zur Temperaturmessung am Crt des Transponders erzeugt. Da das SAW-Element (welches in diesem Fall zusätzlich als Sensor dient) über seinen Code identifizierbar ist, können in der Abfragestation seine individuellen Kennwerte abgespeichert sein Die Abfragestation kann also für eine Vielzahl von solchen Sensorelementen Kennwerte speichern, so daß stets eine vollständige Auswertung der eintreffenden Antwortsignale möglich ist (z.B. Bestimmung der Absoluttemperatur statt nur der Temperaturänderung).

In einer weiteren Ausführungsform der Erfindung wird ein Transponder so realisiert, daß die Abfrage- bzw. Antwortsignale im Transponder durch eine - den Codierkanälen vor- bzw. nachgeschaltete - gemeinsame laufzeiterhöhende Signalstrecke geführt wird. Der laufzeiterhöhende Effekt der gemeinsamen Verzögerungstrecke ermöglicht eine gute Trennung der Antwortsignale von Störeinflüssen, insbesondere von störenden Umgebungs-Reflexionen des Abfragesignals. Die zumindest teilweise gemeinsame Verwendung der Verzögerungsstrecke erlaubt eine Verringerung der für das SAW-Element erforderlichen Fläche bei gleichbleibender Anzahl möglicher Codes. Man ersetzt also insbesondere die nach dem Stand der Technik in jedem einzelnen Codierkanal eines SAW-Tags vorhandene Verzögerungsstrecke und führt bewußt eine gemeinsame zusätzliche Verzögerungsstrecke ein. Dadurch können die nach- bzw. vorgeschalteten Codierkanäle auf eine minimale Länge gebracht werden, ohne die Gesamtlaufzeit des Abfrage- bzw. Antwortsignals im Transponder zu verkürzen.

In aller Regel werden gemeinsame Verzögerungstrecken und Codierkanäle auf einem einzigen SAW-Chip gebildet. Es ist aber durchaus möglich, für die Verzögerungsstrecke einen eigenen SAW-Chip vorzusehen.

Für die identifizierenden signalkomponenten können andere laufzeiterhöhende Signalstrecken verwendet werden als für die den Kalibrier- und/oder Meßzwecken dienenden Signalkomponenten. Denkbar ist auch, daß nur ein Teil der Codierkanäle an der gemeinsamen Verzögerungsstrecke angehängt ist.

Um Chipfläche einzusparen, können der Kalibrier- und ein Codierkanal teilweise überlappen, wobei zur Erzeugung der kalibrierenden oder auch der codierenden Antwortsignalkomponente ein teiltransparenter Reflektor vorgesehen ist.

In einer besonders bevorzugten Ausführungsform werden die Reflektoren so realisiert, daß sie auf der zweiten Harmonischen arbeiten. Die Periode der Reflektorstruktur ist gleich der Wellenlänge $\lambda$ der Arbeitsfrequenz, z.B. 2,45 GHz und die Breite der Elektrodenfinger ist ca. die Hälfte der Periode, z.B. ca. 0,8 $\mu$m bei 2,45 GHz und 128°-LiNbO$_3$ als Substratmaterial.

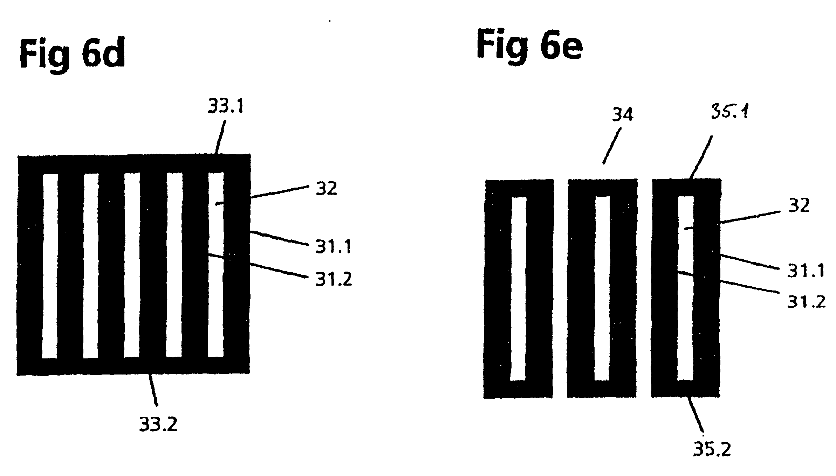

Die Reflektoren funktionieren ähnlich gut für verschiedene Formen der elektrischen Verbindung zwischen den einzelnen Elektrodenfingern. Es eignen sich z.B. alle Finger kurzgeschlossen (Fig. 6d) oder offen, die Finger zu Zweierpaaren verbunden (Fig. 6e) etc. Eine Verbindung kann sowohl an den Enden der Finger oder dazwischen vorhanden sein als auch Kombinationen davon sind möglich.

Die Verwendung der erfindungsgemäßen Reflektoren bringt erhebliche Vorteile im Vergleich zu aus der Literatur bekannten 3. harmonischen Reflektoren:

1. die Breite der Elektrodenfinger ist größer, ca. 8/6 größer, was die reproduzierbare Herstellung deutlich erleichtert,
2. der Reflektionskoeffizient der einzelnen Elektrodenfinger ist wesentlich höher,
3. mit deutlich weniger Elektrodenfinger kann eine hohe Reflektivität erreicht werden, was einen Vorteil für den Platzbedarf auf dem Chip und die Herstellungskosten ist.

Die Verwendung der erfindungsgemäßen Reflektoren bringt auch erhebliche Verteile im Vergleich zu aus der Literatur bekannten Reflektoren, die auf der Grundfrequenz arbeiten:

1. Bei 128°-LiNbO$_3$ und einer Arbeitsfrequenz von 2,45 GHz ist für die fundamentalen Reflektoren eine Periode (pitch) von ca. 0,8 μm erforderlich und eine Breite der Elektrodenfinger von ca. 0.4 μm. Die kostengünstige Herstellung solcher Strukturen ist schwierig und z.B. außerhalb der Spezifikationen für die heute gebräuchlichen i-line Stepper. In 2. harmonischen Reflektoren verdoppelt sich die erforderliche Periode (pitch) und die Breite der Elektrodenfinger ist jetzt ca. 0,8 μm. 2. harmonische Reflektoren können damit problemlos mit den heutigen i-line Steppern hergestellt werden.

2. Zusätzlich ist bei größerer Periode (pitch) und entsprechend größeren Zwischenräumen die Wahrscheinlichkeit von elektrischen Durchschlägen zwischen den Elektrodenfingern durch statische oder pyroelektrische Aufladungseffekte geringer.

Die vorliegende Erfindung beschreibt einen Reflektor für die Anwendung in einem Transponder, der einfacher herzustellen und/oder höhere Reflektivität aufweist als aus dem Stand der Technik bekannt ist.

Werden Reflektoren in einem akustischen Kanal räumlich hintereinander angeordnet, so entstehen insbesondere störende Mehrfachreflektionen zwischen den Reflektoren. Ein störender Einfluß ergibt sich insbesondere in Kombination mit der beschriebenen Art der Codierung der Transponder mittels Positionscodierung. Dies gilt insbesondere, wenn die Reflektoren aus Platzgründen und um Ausbreitungsverluste zu minimieren nahe beieinander liegen, z.B. näher als 1 mm.

Die vorliegende Erfindung beschreibt einen neuen Typ von Offset-Reflektoren, wie er besonders für die Anwendung in Transpondern geeignet ist. Die Offset-Reflektoren entstehen insbesondere aus bekannten Reflektoren durch eine erfindungsgemäße Modifikation derselben.

Die Verwendung von Offset-Reflektoren bringt zusammengefaßt insbesondere folgende Vorteile:

1. Hintereinander liegende Offset-Reflektoren können näher zueinander angeordnet werden, womit kostbare Chipfläche eingespart wird;
2. Hintereinander liegende Offset-Reflektoren können stärkere Antwortsignale erzeugen, da sie näher beieinander liegen und damit weniger Ausbreitungsverluste entstehen, und sie eine höhere Reflektivität aufweisen können, ohne daß die einfachen round-trip-Reflexionen einen störenden Einfluß ausüben;
3. Störende Mehrfachreflexionen, die durch Reflexion am Transducer cder am gegenüberliegenden Reflektor auf der anderen Seite des Transducers entstehen, können erheblich gedämpft werden.

In einer besonders bevorzugten Ausführungsform werden 2. harmonische Reflektoren für die Realisierung von Offset-Reflektoren verwendet, doch die erfindungsgemäße Modifikation kann bei allen Typen von Reflektoren durchgeführt werden. Werden 2. harmonische Offset-Reflektoren verwendet, so ist es insbesondere für eine Arbeitsfrequenz von 2,45 GHz herstellungstechnisch vorteilhaft, am Ende einer jeden Hälfte eine zusätzliche elektrische Verbindung der Elektrodenfinger einzuführen, die sich dann in der Mitte des Reflektor teilweise oder ganz überlappen.

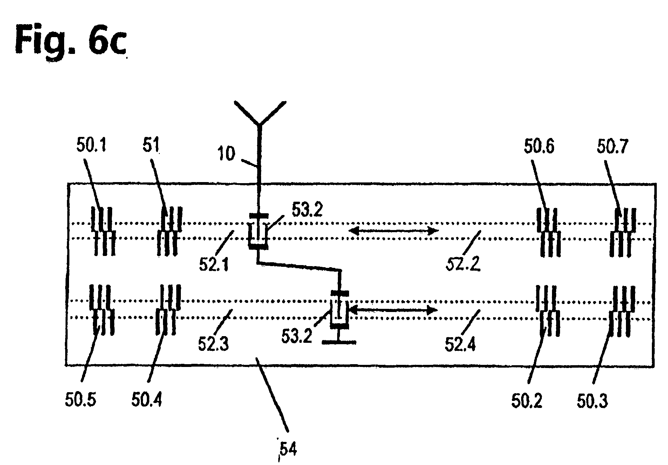

Erfindungsgemäß kann mit Offset-Reflektoren ein Transponderlayout (wie z.B. in Fig. 6c) realisiert werden, wobei alle eingezeichneten Reflektoren 50.1-7 und 51 jeweils Offset-Reflektoren sind. Im Vergleich zu einem ähnlichen Layout mit 4 Transducer, 8 akustischen Kanälen und je einem Reflektor in jedem Kanal, weist die vorliegende Ausführung nur zwei Transducer, 4 akustische Kanäle und je 2 Offset-Reflektoren in jedem Kanal aus. Ein Reflektor 51 wird als Kalibrierreflektor verwendet, wobei dieser die kürzeste Zeitverzögerung erzeugt. Bei gleicher Anzahl von beispielsweise 5 Zeitschlitzen pro Zeitfenster (davon je ein Sperrzeitschlitz) und insgesamt 7 Zeitfenster ergeben sich für das in Fig. 6c realisierte Layout und einem entsprechenden Layout mit 4 Transducer eine Anzahl möglicher Codes von $4^7$ = 16384.

Mit nur zwei Transducer wird die Stärke der Antwortsignale um den Faktor 4 erhöht, da beim Empfang des Abfragesignals durch den Datenträger das Signal nur mehr auf zwei Transducer verteilt wird und nach der Reflexion nur mehr zwei statt 4 Transducer erregt werden.

Mit dem Layout nach Fig. 6c kann zusätzlich die Fläche der Chips 54 bei gleicher Codeanzahl fast halbiert werden, indem von 4 Transducer mit insgesamt 8 normalen Reflektoren auf 2 Transducer mit 8 Offset-Reflektoren gewechselt wird.

Für die Realisation des Offset-Reflektors 51 besteht erfindungsgemäß eine zweite Möglichkeit, indem in allen vier akustischen Kanälen 52.1-4 je ein Reflektor (Offset oder nicht) im genau gleichen Abstand von den Transducern wie 51 gesetzt wird, aber mit deutlich geringeren Reflektivitäten. Dies hat den Vorteil, daß sich ein starkes Kalibriersignal von allen vier Reflektoren aufbaut, daß aber die Störung der Antwortsignale von den Offset-Reflektoren 50.1-7 infolge der geringen Reflektivität der einzelnen Reflektoren geringer ist als wenn nur ein Offset-Reflektor 51 im Kanal 52.1 gesetzt wird. Bei der Realisierung eines starken Kalibrierantwort-Signals kann auch auf andere Fälle als den erwähnten übertragen werden.

In der Praxis verfügt eine erfindungsgemäße Anordnung über eine Vielzahl von mobilen Transpondern bzw. SAW-tags (je nach Anwendung z. B. mehrere zehn oder mehrere zehntausend). Auch können an mehreren Orten Abfragestationen (entsprechend den jeweiligen Systemanforderungen) vorgesehen sein.

Eine Anordnung zur Durchführung einer erfindungsgemäßen berührungslosen Fernabfrage verfügt über eine Abfragestation zum Aussenden eines Abfragesignals und zum Empfangen und Auswerten eines Antwortsignals, mindestens einen mobilen Transponder mit einer Antenne zum Empfangen des Abfragesignals und/oder Abstrahlen des Antwortsignals und eine Codiereinheit mit mehreren parallelen Codierkanälen zum Umwandeln des Abfragesignals in ein identifizierendes Antwortsignal. Im Sinne der Erfindung ist vor bzw. nach der mindestens einen Codiereinheit eine den entsprechenden Codierkanälen gemeinsame laufzeiterhöhende Signalstrecke angeordnet.

Wenn Verzögerungsstrecke und Codiereinheit auf demselben SAW- Element integriert sind, können die entsprechenden Strukturen durch Transducer (Fingerelektrodenstrukturen), 90°-Reflektoren (z.B. Kopplung von zwei parallelen Kanälen durch zwei aufeinander ausgerichtete 90°-Reflektoren) oder durch RMSC-Strukturen (RMSC = Reversing multistrip coupler) gekoppelt werden. Im Unterschied zu den Ausführungsformen mit Transducern (bei welchen parasitäre Reflexionen des Signals bei -15 bis -20 dB auftreten können) sind die 90°-Reflektoren und die RMSC-Strukturen weitgehend frei von störenden internen Reflexionen.

Es ist nicht zwingend, daß die Antwortsignalkomponenten mit z.B. codespezifisch positionierten Reflektoren erzeugt werden. Es können auch mehrere Codierkanäle mit einseitig abstrahlenden Transducern ausgestattet sein, wobei auf der abstrahlenden Seite empfangende Transducer in codespezifischen Abständen angeordnet sind, welche (über elektrische Leitungen) mit der Antenne verbunden sind.

Weitere bevorzugte Ausführungsformen und Merkmalskombinationen ergeben sich aus der nachfolgenden Detailbeschreibung und der Gesamtheit der Patentansprüche.

Die zur Erläuterung der Ausführungsbeispiele verwendeten Zeichnungen zeigen:

Fig. 1        Eine schematische Darstellung einer Anordnung zur Durchführung einer berührungslosen Fernabfrage;

Fig. 2a, b    Zeitdiagramme zur Erläuterung der Positionscodierung in Kombination mit Kalibrierung und Messung;

Fig. 3        Flußdiagramm der Signalverarbeitung zur Auswertung der Information im Antwortsignal;

Fig. 4        Eine schematische Darstellung eines Transponders mit Meß-, Kalibrier- und Codiereinheit sowie einer gemeinsamen Verzögerungsstrecke und einseitig abstrahlenden Transducern;

Fig. 5        Eine schematische Darstellung einer mit einem SAW-Element realisierten Kalibrier- und Codiereinheit mit teilweiser gemeinsamer Verzögerungsstrekke, Transducerkopplung und einseitig abstrahlenden Transducern in den Codierkanälen;

Fig. 6a       Eine schematische Darstellung einer auf einem SAW-Element realisierten Codiereinheit mit gemeinsamer Verzögerungsstrecke, Kopplung über 90°-Reflektoren und einseitig abstrahlenden Transducern in den Codierkanälen;

Fig. 6b       Eine schematische Darstellung einer auf einem SAM-Element realisierten Codiereinheit mit gemeinsamer Verzögerungsstrecke, Kopplung über RMSC-Strukturen und einseitig abstrahlenden Transducern in den Codierkanälen;

Fig. 6c       Eine schematische Darstellung einer auf einem SAW-Element realisierten Kalibrier- und Codiereinheit mit Offset-Reflektoren;

Fig. 6d       Eine bevorzugte Ausführungsform eines 2. harmonischen Reflektors;

Fig. 6e       Eine erfindungsgemäße Ausführungsform eines 2. harmonischen Reflektors;

Fig. 6f       Eine erfindungsgemäße Anordnung von drei Offset-Reflektoren und einen Transducer.

Grundsätzlich sind in den Zeichnungen gleiche Teile mit gleichen Bezugszeichen versehen.

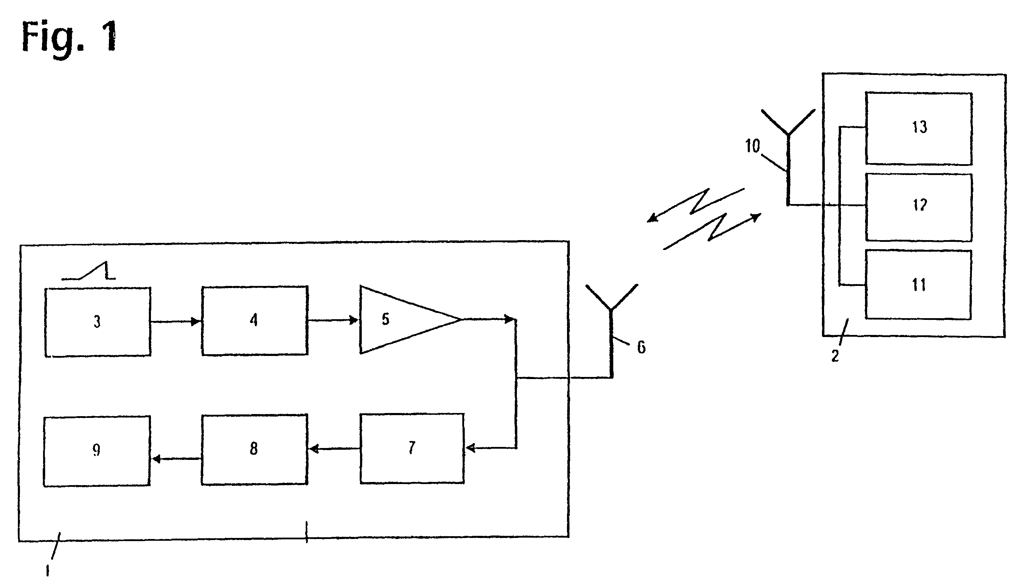

Fig. 1 zeigt ein grobes Blockschaltbild einer Abfragestation 1 und eines Transponders 2. Die Abfragestation 1 sendet ständig Abfragesignale Q (z.B. Chirp-oder Pulssignale) aus und wertet eintreffende Antwortsignale von mobilen, in der Nähe befindlichen Transpondern aus. Beim Transponder 2 handelt es sich um ein passives Element mit einer (vorzugsweise integrierten) Antenne 10, einer Kombination von einer Codier- 11, Kalibrier- 12 und Meßeinheit 13 und elektrischen Leitungen. Er ist z. B. als flaches Plättchen oder als Karte ausgebildet und an dem zu identifizierenden Gegenstand (bzw. am Ort der Messung) als Markierung (Label) angebracht.

Um eine höhere Lesedistanz zu erreichen, ist es im Vergleich zur Aussendung eines kurzen Pulses vorteilhaft, ein an sich bekanntes Chirpsignal (lineare Frequenzrampe) zur Abfrage des Transponders zu benutzen. Ein solches Signal weist eine markant höhere Energie auf, ohne die zulässige Sendeleistung zu überschreiten. Insbesondere ist der Frequenzbereich für die Analyse von Signalen, die einer Summe von cosinusförmigen Antwortsignalen entsprechen, besser geeignet als der Zeitbereich.

Die Abfragestation verfügt über einen Rampengenerator 3, welcher in einer bevorzugten Ausführungsform das Steuersignal für Chirpsignale mit 40 MHz Bandbreite und einer Dauer von $T_{BEOB}$ = 16 ms erzeugt. Die Steilheit der entsprechenden Frequenzrampe beträgt somit 2,5 Hz pro Nanosekunde (Hz/ns). Der Rampengenerator 3 speist einen Trägersignalgenerator 4 (VCO) an, welcher ein frequenzstabilisiertes Chirpsignal bei der Mittenfrequenz von z.B. 2,44 GHz erzeugt. Das resultierende Abfragesignal wird mit einem Verstärker 5 verstärkt und über eine Antenne 6 abgestrahlt.

Nach Verstreichen einer günstig gewählten Verzögerung $T_0$ treffen die Antwortsignale des Transponders 2 ein. Im Demodulator 7 wird durch Rückmischung des Antwortsignals mit dem Abfragesignal für jede Komponente des Antwortsignals ein niederfrequentes Signal erzeugt, dessen Frequenz exakt proportional (obengenannte 2,5 Hz/ns) zur Laufzeit der entsprechenden Signalkomponente ist. Die charakteristischen Laufzeiten der einzelnen Komponenten des Antwortsignals werden dabei in proportionale Frequenzabstände (bezogen auf eine geeignet gewählte Referenzfrequenz) umgewandelt und lassen sich im Frequenzbereich auswerten.

Damit besteht eine eineindeutige Abbildung zwischen Frequenz- und Zeitbereich, was es erlaubt den Sachverhalt in der einen oder anderen Beschreibung darzustellen. Insbesondere ist es für die Darstellung von Teilen der Erfindung zweckmäßig, eine Beschreibung im Zeitraum zu wählen, wobei die Abfragestation in Gedanken anstelle eines Chirpsignals einen kurzen Impuls aussendet und anstelle eines Antwortsignals mit unterschiedlichen Frequenzkomponenten eine Vielzahl charakteristisch verzögerter Antwortsignale vom Transponder refelektiert werden.

Die niederfrequenten Signale werden zur digitalen Weiterverarbeitung und Decodierung einer Einheit mit A/D-Wandler und DSP 8 zugeführt. Der Code wird z. B. in einem Speicher 9 zwischengespeichert.

Im Transponder 2 wird das über die Antenne 10 empfangene Abfragesignal in eine erfindungsgemäße Kombination einer Codier-, Kalibrier-, und Meßeinheit 11 bzw. 12 bzw. 13 gespeist. Unter Kombination ist dabei zu verstehen, daß auch eine Einheit fehlen kann. Die Funktion der verschiedenen Einheiten wird nachfolgend beispielhaft erläutert. Der Transponder ist dabei insgesamt so gestaltet, daß bis zum Empfang der ersten Signalkomponente $R_A$ ein Zeitintervall $T_0$ verstreicht, das vorzugsweise mindestens halb so groß wie das Zeitintervall $T_1$ (längste Laufzeit einer Antwortsignalkomponente) ist. Auf diese Weise kann das Nutzsignal wirkungsvoll von reflexionsbedingten Umgebungsstörsignalen befreit werden (externe Reflexionen).

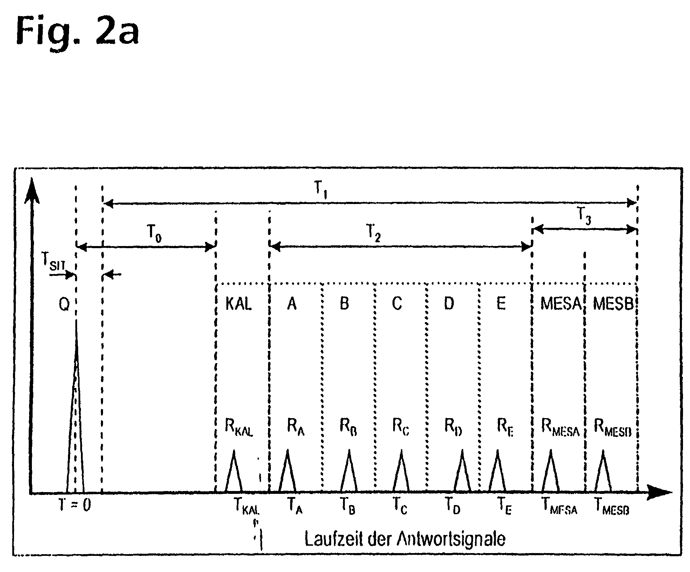

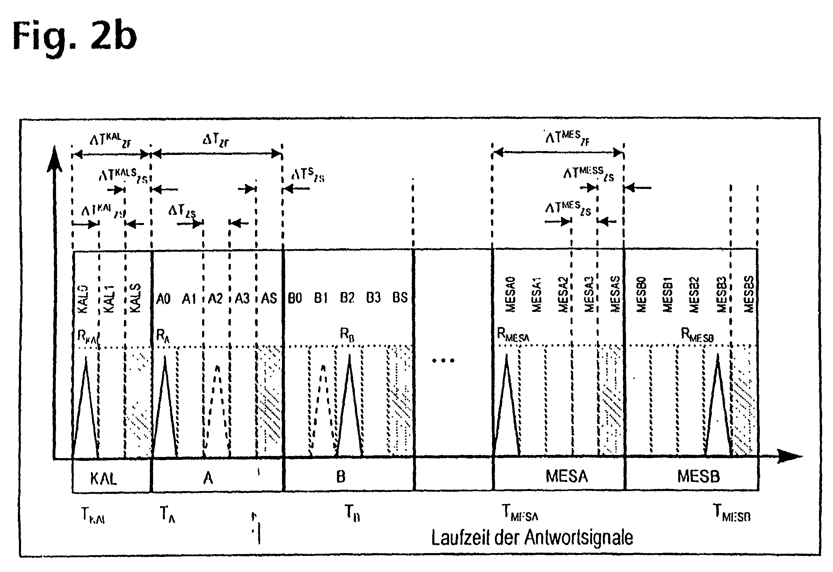

Die Funktion der Codiereinheit 11 und die erfindungsgemäße Signalcodierung-sollen beispielhaft an Fig. 2a, b erläutert werden. Fig. 2a zeigt schematisch eine mögliche Signalkonstellation (auf der Abszisse ist die Zeit t aufgetragen). Zum Zeitpunkt t = 0 wird ein z. B. pulsförmiges Abfragesignal Q mit einer Trägerfrequenz von z.B. 2,44 GHz ausgesendet. Die Pulsdauer beträgt z.B. 25 ns. Ein in Reichweite befindlicher Transponder empfängt das Abfragesignal Q und wandelt es in seiner Codiereinheit 11, die eines oder mehre SAW-Elemente enthält, in eine Vielzahl von Antwortsignalen um, mit beispielsweise fünf identifizierenden Signalkomponenten RA, ..., RE.

Das Zeitintervall $T_2 = T_1 - T_0$, dessen Länge für das System (welches in der Regel eine Vielzahl von Transpondern umfaßt) fest vorgegeben ist, ist aufgeteilt in eine Vielzahl von z.B. 5 identifizierenden Zeitfenstern A,B,... Die Länge der Zeitfenster $\Delta T_{ZF}$ ist, z.B. für alle identifizierenden Zeitfenster gleich groß, z.B. 125 ns.

Alle Transponder einer Anwendung sind so ausgeführt, daß in jedes der fünf, identifizierenden Zeitfenster genau eine identifizierende Signalkomponente zu liegen kommt. Erfindungsgemäß ist die Position, d. h. die genaue Laufzeit, einer identifizierenden Signalkomponente innerhalb des entsprechenden Zeitfensters bis auf störenden Laufzeitschwankungen durch die im Transponder realisierte Codierung bestimmt (Positionscodierung).

Fig. 2b veranschaulicht die Decodierung des Antwortsignals. Alle identifizierenden Zeitfenster A, B, ... mit der Länge $\Delta T_{ZF}$ sind in eine vorgegebene Anzahl, von z.B. je 5 Zeitschlitzen A0, A1, ....B0, B1, ... aufgeteilt. Die minimale Länge der Zeitschlitze $\Delta T_{ZS}$ hängt zusammen mit der Bandbreite des Abfragesystems und der daraus ableitbaren noch erzielbaren Auflösung zweier kurzer Signalpulse. In der bevorzugten Ausführung mit einem Chirpsignal von 40 MHz ergibt sich damit eine minimale Länge von 25 ns.

Die identifizierenden Zeitfenster A,B,.... enthalten erfindungsgemäß einen zusätzlichen Sperrzeitschlitz AS,BS,...mit der Länge $\Delta T^S_{ZS}$. Die Codierung erfolgt so, daß kein identifizierendes Antwortsignal in den Sperrzeitschlitz zu liegen kommt. Damit kann der minimal mögliche Zeitabstand zwischen zwei identifizierenden Signalkomponenten in benachbarten Zeitfenstern nach Bedarf eingestellt werden (vgl. auch Fig. 2b). Im vorliegenden Beispiel ist die Länge des Sperrzeitschlitz gleich der Länge der identifizierenden Zeitschlitzen im entsprechen Zeitfenster gewählt. Das erzielbare Signalzu Geräuschverhältnis wird im Decoder 8 dadurch erhöht.

In einer bevorzugten Ausführung enthalten die identifizierenden Zeitfenster A,B,....E damit 4 identifizierende Zeitschlitze A0,..., A3 bzw. B0, ... B3 etc. und einen Sperrzeitschlitz AS bzw. BS etc. und die Länge aller Zeitschlitze in einem Fenster ist gleich groß, z.B. 25 ns. Daraus ergibt sich eine Länge der Zeitfenster von 5*25 ns=125 ns.

Die Abfragestation muß zur Identifizierung des Transponders die zeitlichen Positionen $T_A$, ..., $T_E$ der identifizierenden Antwortsignale bestimmen und zur Decodierung den vorgegebenen Zeitschlitzer. (hier z. B. A0, B2, ..) zuordnen. Das Muster der so besetzten Zeitschlitze aller identifizierenden Zeitfenster bestimmt den transponderspezifischen Code.

In Fig. 2b sind gestrichelt andere mögliche Positionen von Signalkomponenten angedeutet (Zeitschlitze A2, B1,....) wie sie bei einem zweiten Transponder mit anderem Code vorliegen könnten.

Gemäß der Formel 1 können mit fünf Zeitfenstern und je vier identifizierenden Zeitschlitzen $4^5$ = 1024 Codes realisiert werden. In der Praxis wird man nach Bedarf die Zahl der Fenster oder der Zeitschlitze erhöhen (bei zehn Fenstern zu je vier Schlitzen stehen bereits $4^{10} = 2^{20}$, d.h. 20 Bits zur Verfügung).

Es ist nicht erforderlich, daß die Antwortsignalkomponenten $(R_A,..., R_E)$ vollständig innerhalb eines Zeitschlitzes liegen. Es ist durchaus denkbar, daß sie beidseits aus einem Zeitschlitz herauslappen. Mindestens der "Energieschwerpunkt" muß jedoch hinreichend genau lokalisierbar sein. Das Überlappen reduziert aber das Signalrauschverhältnis und damit die Lesedistanz.

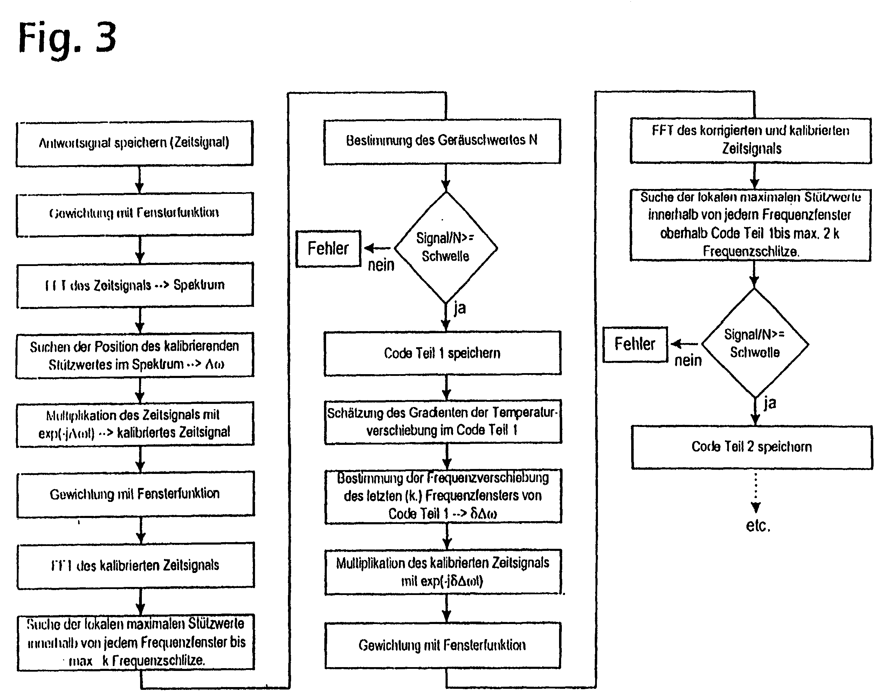

Im folgend wird ein Verfahren zur Decodierung der in den identifizierenden Antwortsignalen enthaltenen Information beschrieben, wie es sich erfindungsgemäß eignet für ein Abfragesystem mit Chirpsignalen. Die einzelnen Verfahrensschritte sind in Fig. 3 aufgeführt.

Die Transformation zur Verarbeitung im Frequenzbereich (Spektrum des Antwortsignals) wird vorteilhaft mittels einer diskreten Fouriertransformation (FFT) unter Nutzung eines digitalen Signalprozessors (DSP) realisiert. Erfindungsgemäß wird die Abtastfrequenz für die Diskretisierung so gewählt, daß die möglichen Antwortsignale exakt mit einem Stützwert der diskreten Fouriertransformation zusammenfallen. Daraus ergibt sich gemäß der bevorzugten Ausführung ein Stützwertabstand von 62,5 Hz (=25 ns x 2,5 Hz/ns). Diese Auflösung im Frequenzbereich entspricht genau der durch die Sendedauer von $T_{BEOB}$ = 16 ms erreichbaren Auflösung von $1/T_{BEOB}$. Die Anzahl der Stützwerte richtet sich nach der Anzahl Zeitschlitze welche der Transponder insgesamt umfaßt. Daraus wiederum läßt sich die Abtastfrequenz bestimmen, die mindestens dem Doppelten der Frequenz des höchsten Stützwertes im relevanten (unter Berücksichtigung der Grundverzögerung $T_0$) Spektrum entspricht. Bei 8 Zeitfenstern ($N_{ZF}$) mit je 5 Zeitschlitzen ($N_{ZS}$) und einer Grundverzögerung $T_0$=1000 ns ergibt sich eine Abtastfrequenz von mindestens 2*(5*8*25 ns+1000 ns)*2,5 Hz/ns = 10 kHz. Prinzipiell ist nun die gesamte in den Antwortsignalen enthaltene Information im Spektrum enthalten, welches völlig analog zum Zeitbereich in Frequenzfenster und Frequenzschlitze eingeteilt ist. Die Decodierung erfolgt nun durch Prüfen, welcher Frequenzschlitz im entsprechenden Frequenzfenster durch ein Antwortsignal besetzt ist.

Zum besseren Verständnis wird für die folgenden Ausführungen wieder auf eine Beschreibung im Zeitbereich gewechselt.

Enthält ein Transponder eine Codiereinheit ohne Kalibriereinheit, so ergeben sich in der praktischen Anwendung erhebliche Probleme. Insbesondere wird der Anwendungsbereich des Systems stark eingeschränkt. Die zur Identifikation notwendige Messung der Laufzeiten TA, TB,..., TE muß so genau erfolgen, daß eine eindeutige Zuordnung zu einem Zeitschlitz möglich ist. Diese ist sicher möglich, wenn die Genauigkeit der Laufzeitmessung mindestens der halben Länge der identifizierenden Zeitschlitze entspricht, z.B. 12,5 ns.

Die Laufzeit der identifizierenden Antwortsignale wird pauschal (für alle gleich) verändert durch:

1. Änderungen in der Länge der Luftstrecke (Lesedistanz),
2. Änderungen der Länge der Antennenzuleitung,
3. Änderungen der Laufzeit in der Abfragestation durch z.B. Alterung oder Temperaturänderung von elektronischen Komponenten,
4. Temperaturbedingte Änderung der im Transponder für alle Antwortsignale gleichen Verzögerung $T_0$-$T_{SIT}$ ($T_{SIT}$ ist der außerhalb des Transponders liegende, meist variable Teil der Grundverzögerung $T_0$),

um einige wichtige pauschale Störeinflüsse zu nennen. So führen, z.B. zusätzliche 2 Meter Antennenkabel und 3 m Luftstrecke bereits zu einer Laufzeiterhöhung von 40 ns, wenn man beachtet, daß das Signal zum Tranponder hin und zurück läuft.

Die Laufzeit der Antwortsignale wird zusätzlich individuell (für jedes Antwortsignal verschieden) verändert durch:

1. temperaturabhängige Variation der Laufzeit in den einzelnen akustischen Kanälen der Codiereinheit,
2. Änderungen der Signalgeschwindigkeit in den einzelnen akustischen Kanälen der Codiereinheit,

um einige wichtige individuelle Störeinflüsse zu nennen.

Es wird ein kalibrierendes Antwortsignal $R_{KAL}$ verwendet, das die pauschalen Störeinflüsse auf die Laufzeiten der Antwortsignale mißt. Dazu wird erfindungsgemäß genau ein Antwortsignal erzeugt, dessen Position in einem Zeitschlitz des kalibrierenden Zeitfensters dem Abfragesystem exakt und im voraus bekannt ist. $T_{KAL}$ bezeichnet die Laufzeit des kalibrierenden Antwortsignals.

Im folgenden wird ein Verfahren zur Reduktion der pauschalen Störeinflüsse beschrieben, wie es sich erfindungsgemäß eignet für das oben beschriebene Abfragesystem mit Chirpsignalen. Dazu wird wiederum in eine Beschreibung im Frequenzraum gewechselt.

Als Folge der genannten, insbesondere der pauschalen Störeinflüsse liegt das Spektrum des Antwortsignals nicht mehr wie gewünscht auf dem diskreten Stützwertraster der FFT. Die Verschiebungen können sogar ab einem gewissen Maß zu einer falschen Codelesung führen. Erfindungsgemäß wird daher wie erwähnt ein kalibrierendes Antwortsignal erzeugt, dessen durch den Transponder erzeugte Verzögerung der Abfragestation bekannt und für alle Transponder einer Anwendung gleich ist.

Dieses kalibrierende Zeitfenster kann vorzugsweise als erstes Zeitfenster KAL auf dem Transponder angebracht sein (vgl. Fig. 2a, b). In anderen Ausführungen kann das kalibrierende Zeitfenster aber auch vorteilhaft zwischen den identifizierenden Zeitfenstern oder aber am Ende liegen.

Mit geeigneter Gewichtung der Abtastwerte vor der Transformation (sogenannte FFT-Fenster) kann eine gute Dekorrelation der einzelnen identifizierenden Antworten im Spektrum erreicht werden, wenn ein gewisser Abstand zwischen kalibrierendem Zeitschlitz (KAL0, $\Delta T^{KAL}{}_{ZS}$) und den nachfolgenden identifizierenden Zeitschlitzen gegeben ist. Dieser Abstand wird durch den kalibrierenden Sperrzeitschlitz (KALS, $\Delta T^{KALS}{}_{ZS}$) gegeben. Im Spektrum kann nun die exakte Lage des Maximums des kalibrierenden Antwortsignals ermittelt werden. Dabei ist nur die nähere Umgebung der erwarteten Lage zu untersuchen, um eventuelle Störsignale wie z.B. Tripelreflex auszuscheiden. Dies kann mit der bekannten Matched Filter Technik oder Korrelation geschehen, da die Sollposition des kalibrierenden Antwortsignals dem Abfragegerät bekannt ist. Als Resultat ergibt sich ein genauer, vom Stützwertraster unabhängiger Wert für den Frequenzfehler $\Delta\omega$ in Bezug auf die theoretisch, vom Transponder unabhängige, zu erwartende Frequenz des kalibrierenden Antwortsignals.

Durch anschließende Multiplikation (Mischung) des abgetasteten Antwortsignals im Zeitbereich, wobei das Zeitsignal vorzugsweise im Signalprozessor gespeichert bleibt, mit der komplexen Funktion

$$f(t) = e^{-j\Delta\omega t}, \qquad (2)$$

erreicht man eine spektrale Verschiebung des Zeitsignals um den Frequenzfehler $\Delta\omega$. Das nun kalibrierte, komplexe Zeitsignal wird wiederum derselben FFT unterworfen, welche zur Ermittlung des Frequenzfehlers benutzt wurde. Die Spektren aller Antwortsignale liegen nun fast exakt auf den gewünschten Stützwerten der FFT und ein Dekodierungsfehler infolge nicht erfaßter pauschaler Laufzeitverschiebung ist somit ausgeschlossen.

Das Abfragegerät kann im folgenden die spektralen Stützwerte jedes identifizierenden Zeitschlitzes, resp. Frequenzschlitzes, nach seiner Amplitude abfragen. Da durch die Art der verwendeten Positionscodierung jeweils ein Frequenzschlitz pro Frequenzfenster belegt sein muß, entspricht der maximale Stützwert innerhalb eines identifizierenden Frequenzfensters der gesuchten Position des identifizierenden Antwortsignals.

Um für den Fall, daß schwache Empfangssignale vorliegen, Fehler in der Decodierung zu vermeiden, wird im weiteren außerhalb des durch das Antwortsignal belegten Frequenzbereichs, vorzugsweise innerhalb des Bereichs, der der Grundverzögerung $T_0$ entspricht, der Geräuschpegel des in der Abfragestation eintreffenden Gesamtsignals ermittelt. Ist das Verhältnis von detektierten Maxima in den identifizierenden Frequenzschlitzen zum Geräuschpegel zu gering, wird die decodierte Information verworfen.

Das erfindungsgemäß kalibrierte Spektrum zur Auswertung des Antwortsignals korrigiert auch insbesondere die temperaturabhängige Verschiebung der Grundverzögerung $T_0$. Hingegen wird der individuelle Anteil der Laufzeitverschiebung der Antwortsignale nicht korrigiert. Dies läßt sich anhand der Situation, wie sie beispielhaft in Fig 2a, b dargestellt ist, erläutern. Das kalibrierende Zeitfenster (KAL) mit der Länge $\Delta T^{KAL}{}_{ZF}$ liegt in dieser Ausführung vor den identifiziehenden Zeitfenstern. Die Verschiebungen der Grundverzögerung T0 kann in dieser Anordnung korrigiert werden. Hingegen ist für die nachfolgenden identifizierenden Antwortsignale (A,B,..) die Temperatur nach wie vor wirksam. Bei 100° Temperaturveränderung und einem Temperaturkoeffizienten von ca. 70 ppm/°C für Lithiumniobat ergibt dies eine relative Laufzeitverzögerung von 0,7%. Diese Verschiebung beginnt sich nachteilig auf die Decodierung auszuwirken, wenn die Verschiebung aller identifizierenden Zeitfenster (A, B,...) im Zeitintervall $T_2$ die Hälfte einer Zeitschlitzdauer $\Delta T_{ZS}$ erreicht, z. B. 25 ns/2 =12,5 ns. Es ist ein vorteilhaftes Merkmal der erfindungsgemäßen Positionscodierung, daß sich dieser individuelle Störeinfluß erst nachteilig auszuwirken beginnt, wenn der bevorzugten Ausführung die Anzahl aller identifizierenden Zeitschlitze größer als z.B. ca 70 wird. In der bevorzugten Ausführung mit jeweils 5 Zeitschlitzen sind damit für einen Temperaturbereich von 100°C maximal ca. 70/5=14 identifizierende Zeitfenster (A,B,...) oder ca. 70*4/5=56 identifzierende Zeitschlitze nutzbar ohne eine weitere Korrektur der Kalibrierung.

Für Transponder mit mehr identifizierenden Zeitschlitzen oder für einen höheren Temperaturbereich kann entweder die Länge der Zeitschlitze verlängert werden, ein zweiter kalibrierender Zeitschlitz eingeführt werden oder mit Hilfe eines Gradientenalgorithmus (Korrektur der Kalibrierung) eine weitere Frequenzkorrektur $\delta\Delta\omega$ ermittelt werden. Dazu wird aus der theoretisch linear zunehmenden Verschiebung der spektralen Schwerpunkte der kalibrierten und korrekt decodierten Antwortsignale (bis und mit z.B. Zeitschlitz K) durch Korrelation mit dem Sollantwortsignal die weitere Frequenzkorrektur $\delta\Delta\omega$ ermittelt. Der Wert $\delta\Delta\omega$ entspricht dabei erfindungsgemäß dem aus der Gradientenverfolgung bestimmten Frequenzfehler, welcher der temperaturbedingten individuellen Laufzeitverschiebung für den letzten bisher ausgewerteten, indentifizierenden Zeitschlitz K entspricht.

In gleicher Weise wie bereits beschrieben, wird für die nächste Anzahl Zeitschlitze (I,J,...) des gespeicherten Antwortsignals erneut mittels besagter komplexer Multiplikation (Formel 2) im Zeitbereich das Spektrum des Zeitsignals spektral um den Wert $\delta\Delta\omega$ verschoben und erneut fouriertransformiert. Für besagte nächste Anzahl Zeitschlitze (I,J,...) ist dann die temperaturbedingte Verschiebung wiederum nicht störend. Die entsprechenden identifzierenden Antwortsignale können nun ebenfalls decodiert werden.

Zur weiteren Sicherung der Decodierung kann der temperaturbedingte Gradient in der Verzögerung aufeinanderfolgender Zeitschlitze in besagter zweiter Anzahl Zeitschlitze ermittelt werden und mit dem Frequenzkorrekturwert $\Delta\omega$ der ersten Anzahl verglichen werden. In einer weiteren Ausführung kann die Signalqualität durch Filterung aufeinanderfolgender Detektionsvorgänge (mehrere Chirp von je $T_{BEOB}$=16 ms Dauer) verbessert werden.

Zusammenfassend ergibt sich also z.B. folgender Verfahrensablauf (vgl. Fig. 3):

a) Speicherung des Antwortsignals als Zeitsignal in der Abfragestation;

b) Gewichtung mit einer geeigneten Fensterfunktion;

c) Bestimmung des Spektrums des gewichteten Zeitsignals (diskrete Fouriertransformation);

d) Bestimmen der Position des kalibrierenden Stützwertes im Spektrum (Ermittlung von $\Delta\omega$);

e) Erzeugen eines kalibrierten Zeitsignals durch Multiplikation des abgespeicherten Zeitsignals mit exp $(-j\Delta\omega t)$ ;

f) Gewichtung mit einer geeigneten Fensterfunktion;

g) Berechnung der diskreten Fouriertransformation des kalibrierten Zeitsignals;

h) Ermitteln der lokal maximalen Stützwerte innerhalb eines jeden Frequenzfensters mit max. k Frequenzschlitzen;

i) Bestimmung des Geräuschpegels;

j) Abbrechen der weiteren Auswertung sofern das Verhältnis Signal zu Rauschen unterhalb einer vorgegebenen Schwelle ist;

k) Codeteil 1 speichern;

l) Schätzung des Gradienten der temperaturbedingten Verschiebung innerhalb des gewählten Codeteils 1;

m) Bestimmung der Frequenzverschiebung des letzten (d.h. k-ten) Frequenzfensters vom Codeteil 1, d.h. des Wertes $\delta\Delta\omega$;

n) Korrektur des kalibrierten Zeitsignals durch Multiplikation mit exp$(-j\delta\Delta\omega t)$;

o) Gewichtung mit einer geeigneten Fensterfunktion;

p) Bestimmung der diskreten Fouriertransformation des korrigierten kalibrierten Zeitsignals;

q) Suche des lokal maximalen Stützwertes innerhalb von jedem Frequenzfenster zu den übrigen (höherliegenden) Codeteilen (bis max. 2k Frequenzschlitze);

r) Erneute Überprüfung des S/N-Verhältnisses;

s) Zweiten Codeteil speichern;

t) Sinngemäße Abarbeitung des ganzen Codes.

Nachfolgend wird ein Verfahren zum Bestimmen der in den messenden Antwortsignalen enthaltenen Information beschrieben, wie es sich erfindungsgemäß eignet für ein Abfragesystem mit Chirpsignalen und Transpondern, die zumindest eine Identifizier-Einheit enthalten.

Erfindungsgemäß werden in besagtem Transponder mindestens zwei akustische Kanäle mit je einem Zeitfenster (MESA, MESB) mit der Länge $T_{MESA}$, $T_{MESB}$ für Meßzwecke insbesondere für die Messung der Temperatur des Transponders verwendet. (In Fig. 2a bezeichnet $T_3$ die Laufzeit der messenden Antwortsignale). Es ist dabei vorteilhaft, wenn die beiden Kanäle möglichst stark überlappen, damit die messenden Antwortsignale ($R_{MESA}$, $R_{MESB}$) einen langen, gemeinsamen Signalweg aufweisen. Für die Messung der Temperatur eignet sich z.B. die in den Patenten von X-Cyte beschriebene Methode der Messung der Phase der beiden messenden Antwortsignale. Aus der Veränderung der Differenz der beiden Phasen kann die Temperaturveränderung bestimmt werden. Die Ausführung dieser Phasenmessung ist im Prinzip bekannt und in den Patenten von X-Cyte beschrieben.

In einer bevorzugten Ausführung enthalten die messenden Zeitfenster (MESA, MESB) $\Delta T^{MES}_{ZF}$ nur gerade einen Zeitschlitz und einen Sperrzeitschlitz und sind nach den identifizierenden Zeitfenstern angeordnet. Die Länge der entsprechenden Zeitschlitze (MESA0, ..., MESB0,..) $\Delta T^{MES}_{ZS}$ wird so ausgelegt, daß im interessiereden Temperaturbereich keine Winkeldoppeldeutigkeit (mehr als 360°) entsteht und eine hinreichend gute Empfindlichkeit erreicht wird. In einer bevorzugten Ausführung ist die Länge der messenden Zeitschlitze (MESA0, MESB0) und die Länge des entsprechenden Sperrzeitschlitzes (MESAS, MESBS) $\Delta T^{MESS}_{ZS}$ z.B. 25 ns. Bei Lithiumniobat ergibt sich damit, z.B. für 100° Temperaturänderung eine relative Phasenveränderung von ca 306°/100°C oder aber ca. 3°/°C.

Mit obiger Anordnung ist nur die Messung der relativen Temperatur möglich. Die absolute Temperatur kann berechnet werden, da mit der erfindungsgemäßen Kombination von Codier- und Meßeinheit die Möglichkeit besteht, in der Abfragestation Kalibrierinformationen abzuspeichern, die zum jeweiligen Transpondercode gehören.

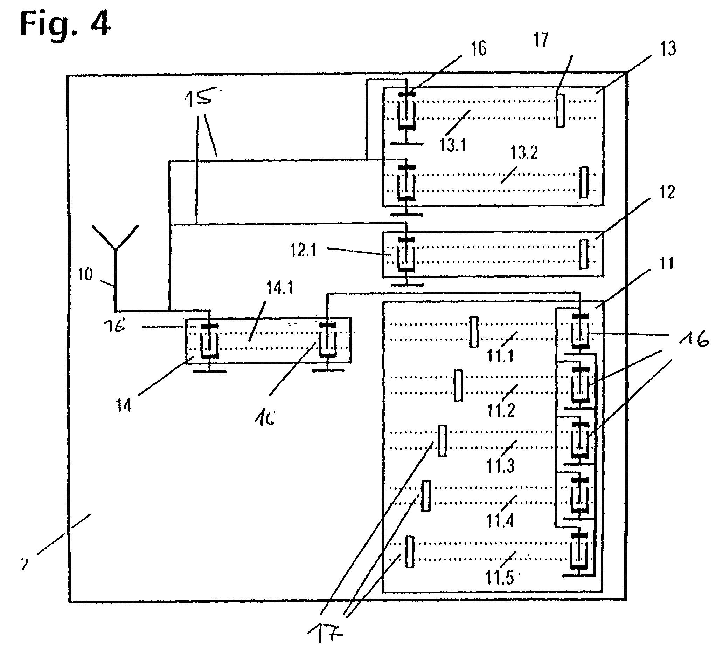

Die Codier- und Kalibriereinheit 11 bzw. 12.1 ist in der bevorzugten Ausführung als ein SAW-Element ausgebildet (vgl. Fig. 4). Die Codiereinheit 11 verfügt im vorliegenden Beispiel über fünf Codierkanäle 11.1 bis 11.5, welche je eine identifizierende Antwortsignalkomponente erzeugen. Die Codierkanäle sind physikalisch als fünf akustische Kanäle verwirklicht. In jedem akustischen Kanal sind je eine Transducerelektrode 16 und ein Reflektor 17 realisiert. Die Reflektoren sind so angeordnet, daß die fünf erwähnten Codierkanäle 11.1, ..., 11.5 mit codespezifischer Länge gebildet werden.

Zwischen Antenne 10 und Codiereinheit 11 ist die ebenfalls auf einem SAW-Element implementierte Verzögerungstrecke 14. Sie stellt sicher, daß das Antwortsignal die bereits erwähnte Grundverzögerung $T_0$ hat. Die Grundverzögerung $T_0$ wird erfindungsgemäß nicht in den einzelnen Codierkanälen 11.1 bis 11.5, sondern in einem vor- bzw. nachgeschalteten separaten Kanal erzeugt. Wenn nämlich die Grundverzögerung in jedem einzelnen Codierkanal (quasi zusammen mit der Codierung) ausgeführt wird, dann wird insgesamt viel mehr Substratoberfläche benötigt, als bei der erfindungsgemäßen Ausführung. Es ist dabei nicht zwingend, daß die ganze Verzögerung $T_0$ (initial delay) in der getrennten Signalstrecke 14 realisiert ist.

Das von den Antenne 10 empfangene Abfragesignal wird also über eine erste Transducerelektrode 16 in den akustischen Kanal 14.1 eines SAW-Element eingekoppelt, dort um eine Zeit $t_{delay}/2$ ($<= T_0/2$) verzögert, dann über eine zweite Transducerelektrode 16 ausgekoppelt und über eine elektrische Leitung zur Codiereinheit 11 geführt. In dieser wird das Abfragesignal entsprechend der jeweiligen Länge der Codierkanäle reflektiert und verzögert, dann ein zweites Mal in der Signalstrecke 14 um $t_{delay}/2$ verzögert. Die gesamte Signalverzögerung durch die Signalstrecke 12 ist also 2 $t_{delay}/2 = t_{delay}$. Um z.B. $t_{delay} = 1$ μs zu erzeugen, wird auf einem 128-LiNbO$_3$-Substrat eine Länge von L = 1990 μm, d.h. etwa 2 mm benötigt. Vorzugsweise ist $t_{delay}$ etwa gleich groß oder geringfügig (z.B. 10 %) größer als $T_2$.

In Fig. 4 ist im Sinne einer Option eine Erweiterung der SAW-Einheit 11 gezeigt, die darin besteht, daß neben der Codiereinheit 11 weitere Kalibrier- 12 und Meßeinheiten 13 mit akustischen Kanälen vorgesehen sind. Diese weiteren Einheiten sind z.B. direkt an der Antenne 10 angeschlossen, können aber auch über die Verzögerungsstrecke 14 geführt werden. Die Kalibriereinheit erzeugt in einem akustischen Kanal, der entsprechend den Codierkanälen aufgebaut und bei allen Transpondern zumindest einer Anwendung gleich ist, das besagte, kalibrierende Antwortsignal ($R_{KAL}$). Durch unterschiedliche Positionierung des Reflektors im Kalibrierkanal kann bei sonst gleicher Codierung eine gruppenspezifische Codierung erzeugt werden, indem die Position des kalibrierenden Antwortsignals als Gruppencode verwendet wird. Die Meßeinheit verfügt z.B. über zwei Kanäle 13.1, 13.2 zur Erzeugung von messenden Antwortsignalkomponenten (welche insbesondere für die Temperaturmessung verwendet werden können).

Den Einheiten 12 und 13 kann z.B. auch eine eigene laufzeiterhöhende Signalstrecke eingeschoben werden. D.h. es können in einem Transponder gewünschtenfalls auch mehrere unterschiedlich lange, gemeinsame Verzögerungsstrecken vorgesehen sein.

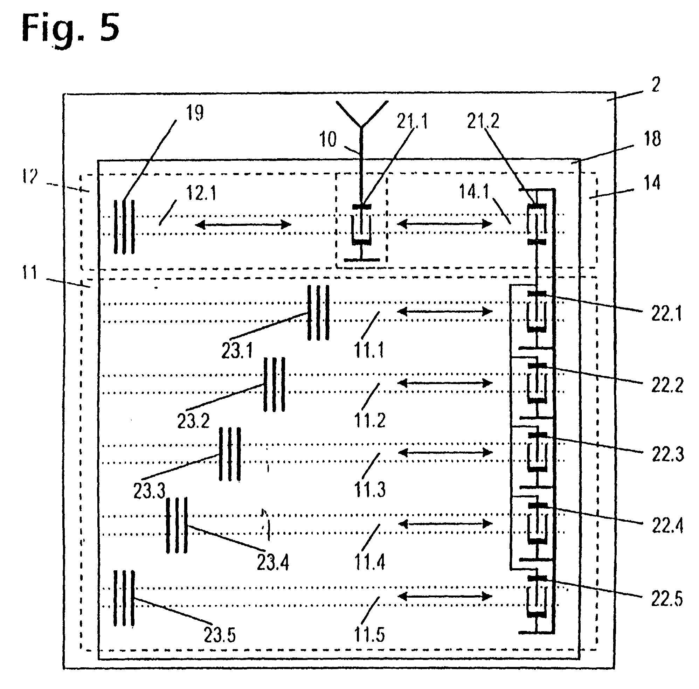

Fig. 5 zeigt eine bevorzugte Ausführungsform der Erfindung, wobei eine Codier- und Kalibriereinheit in einer Anordnung, die Fig 2 entspricht, auf einem einzigen SAW-Chip 18 realisiert ist. Neben den in diesem Beispiel fünf Codierkanälen 11.1 bis 11.5 sind zusätzlich ein Kanal 14.1 als laufzeiterhöhende Signalstrecke und ein Kalibrierkanal 12.1 vorgesehen. Vorzugsweise wird die besagte Verzögerungsstrecke in dieser Ausführung etwas kleiner sein als $T_0/2$ damit der Tripelreflex aus diesem Kanal 14.1 noch vor dem kalibrierenden Antwortsignal aus Kanal 12.1 liegt.

Der Transducer 21.1 strahlt in dieser Ausführungsform in beide Richtungen ab, d.h einerseits zu einem 180°-Reflektor 19 und andererseits zu einem Transducer 21.2. Am Transducer 21.2 sind parallel fünf einseitig abstrahlende Transducer 22.1, ..., 22.5 angeschlossen. Sie strahlen Oberflächenwellen in Richtung der codespezifisch positionierten Reflektoren 23.1, ..., 23.5.

Der Vorteil der geometrischen Anordnung gemäß der bevorzugten Ausführung besteht darin, daß die elektrischen Verbindungsleitungen (busbars) zwischen den auf einer Linie am Rand des Chips liegenden Transducerelektroden 21.2, 22.1 bis 22.5 relativ kurz sind und daher Widerstandsverluste minimiert werden können. Die in Fig. 5 gezeigten Verbindungsleitungen sollen einen kleinen Widerstand im Sinne des folgenden Kriteriums aufweisen:

$$2\pi f * R * C << 1, \qquad (3)$$

R bezeichnet den parasitären Leitungswiderstand, C die gesamte statische Kapazität der IDT-Elektrodenstruktur (IDT = interdigital transducer) und f die Arbeitsfrequenz (z.B. f = 2,45 GHz).

In einer weiteren Ausführung der Kombination von Codier- 11, Kalibriereinheit 12 und Verzögerungsstrecke 14 werden erfindungsgmäß die störenden internen Reflexionen an den Transducern 21.2, 22.1 bis 22.5 durch die nachfolgend beschriebenen Maßnahmen (insbesondere 90°-Reflektoren und RMSC-Strukturen) gegenüber den Nutzsignalkomponenten stark (z. B. mehr als-20 dB) reduziert.

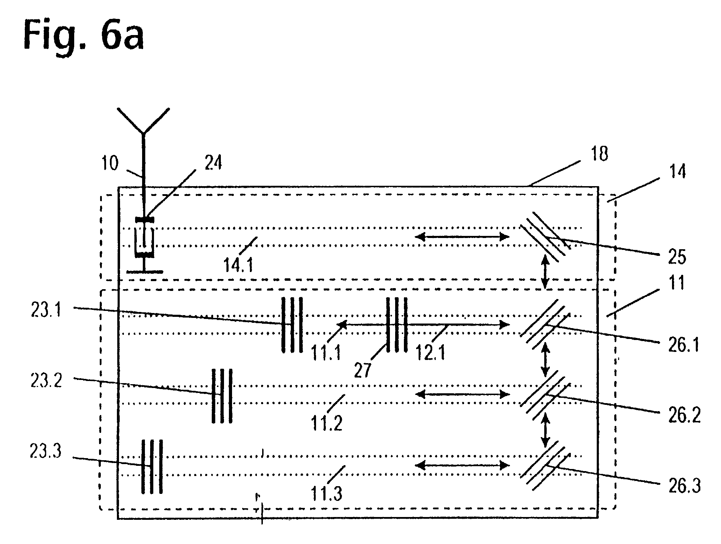

Fig. 6a zeigt eine Variante zu Fig. 5, bei welcher die Kopplung, dargestellt in einer Ausführung mit drei Codierkanälen, zwischen den akustischen Kanälen 14.1, 11.1 bis 11.3 (Fig 6a) nicht mit Hilfe von Transducerelektroden 22.2 und 22.1 bis 22.5 (Fig. 5) sondern mit entsprechend angeordneten 90°-Reflektoren 25, 26.1 bis 26.3 erfolgt. Der in der Darstellung gemäß Fig. 6a zuoberst angeordnete Kanal 14.1 verfügt über einen 90°-Reflektor 25, welcher die Oberflächenwellen aus dem Kanal im 90°-Winkel hinausreflektiert (in der Darstellung gemäß Fig. 6a nach "unten"). Die 90°-Reflektoren 26.1 bis 26.3 sind so auf den 90°-Reflektor 25 ausgerichtet, daß ein Teil der im 90°- Winkel ausgekoppelten Oberflächenwelle in den jeweiligen Kanal 11.1 bis 11.3 eingekoppelt wird. Dort läuft sie zu den Reflektoren 23.1 bis 23.3 (180°-Reflektoren), wird reflektiert und über die 90°-Reflektoren wieder zurück in den Kanal 14.1 gelenkt.

Der Winkel zwischen den schräg verlaufenden Fingerelektroden der 90°-Reflektoren und der kristallografischen x-Koordinate ist nahe bei 45° und hängt von der Anisotropie des benutzten Substrats ab. (Für die - in anderem Zusammenhang an sich bekannte - Bemessung solcher 90°-Reflektoren wird auf das Buch "Surface-wave devices for signal processing", D. Morgan, Elsevier, 1985, verwiesen.)

Es versteht sich, daß zumindest die 90°-Reflektoren 26.1, 26.2 teiltransparent sein müssen.

Eine Variante könnte auch darin bestehen, daß der Codierkanal 11.1. und der Kalibrierkanal 12.1 (Fig 6a) teilweise zur Überlappung gebracht werden, indem in den Codierkanal 11.1 ein zweiter teildurchlässiger Reflektor 27 gebracht wird. Der Reflektor 27 erzeugt in dieser Anordnung ein kalibrierendes Antwortsignal und läßt zugleich einen Teil der einfallenden Oberflächenwelle passieren.

Die Ausführungsform gemäß Fig. 6a hat folgende Vorteile:

> 1. Die Breite der Elektrodenfinger ist bei schrägen Reflektoren vergrößert, z.B. bei 90° Reflektoren um den Faktor $\sqrt{2}$ größer als die entsprechende Breite bei 180° Reflektoren (senkrechter Einfall der Welle). Das ist ein wichtiger Vorteil für den 2,45 GHz-Frequenzbereich.
> 2. Die Widerstandsverluste in den Elektroden sind kleiner, da kein elektrischer Stromfluß von einer Elektrode zur anderen existiert (alle Ströme sind lokal).
> 3. Es gibt nahezu keine störenden internen Reflexionen, wodurch insbesondere die störenden Dreifachreflexionen (zwischen den Reflektoren und Transducern in Fig. 5) wegfallen.
> 4. Die Wellenausbreitung quer zur x-Koordinate des Kristalls führt zusätzliche und im Rahmen der Erfindung bevorzugte Signalverzögerungen ein. Entsprechend kann die Chipfläche optimiert bzw. minimiert werden.

Insgesamt zeichnet sich diese Ausführungsform somit durch eine große Flexibilität bei der Dimensionierung, eine heute erleichterte Herstellbarkeit (höhere Ausbeute) und durch erheblich reduzierte interne Störreflexe aus.

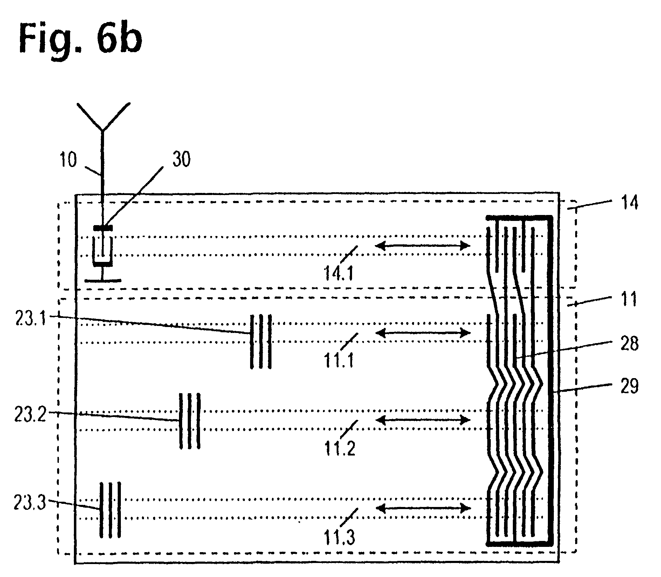

Fig. 6b zeigt eine weitere Möglichkeit, den laufzeitverzögernden Kanal 14.1 mit codierenden oder kalibrierenden Kanälen, beispielsweise drei Codierkanälen 11.1 bis 11.3 zu koppeln. Die Kopplung erfolgt mit einer RMSC-Struktur 28 (Reversing multistrip coupler), wie sie beispielhaft in Fig. 6b dargestellt ist.

Es handelt sich dabei um eine aus anderen Anwendungen bekannte Elektrodenstruktur die in der vorliegenden Ausführung von einer ring- (bzw. C-)förmigen Elektrode 29 (ring ground electrode) umgeben ist, um technologisch aufwendige und damit teure Elektrodenüberkreuzungen vermeiden zu können. Weitere Erläuterungen zu der als solchen bekannten RMSC-Struktur erübrigen sich (vgl. z.B. E. Danicki, "A SAW resonator filter exploiting RMSCs", 1994, Frequency Control Symp. Proc.).

Die RMSC-Struktur kann auf der Grundfrequenz und der zweiten Harmonischen arbeiten. Die Breite der Elektroden bei Betrieb in der Grundfrequenz ergibt sich zu $\lambda/6$ (z. B. $\lambda/6 = 0{,}26\ \mu m$ bei Grundfrequenz 2,45 GHz). Bei Betrieb in der zweiten Harmonischen ergibt sich eine vorteilhafte Verdoppelung der Elektrodenbreite (z. B. $0{,}52\ \mu m$).

RMSC-Strukturen haben diverse Vorteile für die erfindungsgemäße Realisierung von z.B. Codier- und Kalibrierkanal mit gemeinsamer Verzögerungsstrecke 14 auf einem SAW Chip:

> 1. Die bekannte elektromechanischen Kopplung der Oberflächenwellen führt dazu, daß eine störenden Rückwärtsreflexion in denselben Kanal sehr schwach ist. Insbesondere können die störenden Reflexionen am Transducer 21.2 und Mehrfachreflexionen in den Codierkanälen 11.1 bis 11.5 (Fig. 5) sehr stark reduziert werden.
> 2. Weiter ist die Wellenübertragung und Reflexion von einem Kanal in den anderen fast vollständig, wenn die Zahl der Elektrodenfinger hinreichend groß ist, d.h. von der Größenordnung $3 * (\Delta V/V)^{-1}$, wobei $\Delta V/V$ der an sich bekannte Kopplungsfaktor zur Beschreibung der Stärke des Piezoeffektes bei akustischen Oberflächenwellen ist.

Die Ausführungsform gemäß Fig. 6b verwendet also eine RMSC-Struktur. Die Elektrode 29 umgreift alle vier Kanäle 14.1, 11.1 bis 11.3. Die im obersten Kanal 14.1 auf die RMSC-Struktur 28 einfallende Welle wird beispielsweise in die drei Kanäle 11.1 bis 11.3 gekoppelt und mit umgekehrter Ausbreitungsrichtung ausgestrahlt. Sinngemäß werden die codespezifischen Reflexionen aus den Kanälen 11.1 bis 11.3 in den Kanal 14.1 zurückgeführt und dort in entgegengesetzter Richtung ausgestrahlt. Gemäß einer besonders bevorzugten Ausführungsform sind die Elektrodenfinger zwischen den Codierkanälen 11.1 bis 11.3 V-förmig deformiert. Dadurch wird verhindert, daß Oberflächenwellen zwischen den Codierkanälen 11.1 bis 11.3 ausgestrahlt werden. Selbstverständlich können anstelle der V-förmigen auch andere Deformationen vorgesehen sein (zur Verhinderung unerwünschter SAW-Abstrahlung).

Denkbar wäre auch, daß sowohl in Fig. 5 als auch in Fig. 6a und 6b die Reflektoren 23.1 bis 23.3 durch Ausgangstransducer ersetzt werden, so daß das die in den einzelnen Codierkanälen 11.1 bis 11.3 einfallenden Abfragesignale nicht reflektiert und über den Transducer 21.1, respektive 24, respektive 30 zur Antenne 10 geleitet werden, sondern daß die in den Codierkanälen 11.1 bis 11.3 erzeugten Antwortsignale über die erwähnten Ausgangstransducer direkt auf die Antenne 10 geführt werden.

Als Substrat für das SAW-Element wird vorzugsweise 128-LiNbO$_3$ verwendet. Dieses Material zeichnet sich durch starke piezoelektrische Kopplung aus, was wichtig zur Verminderung der Verluste von verhältnismäßig breitbandigen Transducern ist. Weiter hat dieses Material eine hohe Oberflächenwellen-Geschwindigkeit und ein niedriges Niveau parasitärer Bulk-Wellen. Andere Substrate sind jedoch ebenfalls möglich. Für die Ausführungsform mit den 90°-Reflektoren beispielsweise ist YZ-LiNbO$_3$ von Vorteil wegen den geringen Streuverlusten (diffraction losses).

Die Transducer in allen Ausführungen können als sog. "split electrode transducers" ausgebildet sein, welche auf der dritten Harmonischen arbeiten. In diesem Fall ist die Breite der Elektrode für 128-LiNbO$_3$ etwa 0,6 µm (so auch die Abstände zwischen den Elektrodenfingern). Für sog. "selfmatched" Transducer (d.h. Transducer, bei welchen der imaginäre Teil der Admittanz nahe bei Null ist), benötigt man eine Struktur mit etwa 25 gespaltenen Elektroden (50 Elektrodenfinger). Der Realteil der Admittanz ist nahe bei 50 Ohm, wenn die Apertur nahe bei 100 λ (λ = Wellenlänge der Oberflächenwelle, z. B. 1,6 µm bei 2,45 GHz) ist. Die Dauer der Stoßantwort eines solchen Transducers ist etwa 15 ns.

Die Reflektoren können entweder bei der Grundfrequenz oder bei der dritten Harmonischen arbeiten. Im erstgenannten Fall werden für eine starke Totalreflexion etwa 40 bis 50 Elektrodenfinger gebraucht. Dies bedeutet eine Zeitverzögerung innerhalb der Reflektoren von etwa 16 ns. Da die herstellungstechnischen Anforderungen an Elektroden mit einer Breite von 0,4 µm hoch sind, werden oft gespaltene Elektrodenfinger (split electrodes) verwendet, welche bei der dritten Harmonischen arbeiten und deren Breite beträgt ca. 0,6 µm für LiNbO$_3$ bei 2.45 GHz. Die Zahl der gespaltenen Elektroden liegt im Bereich von typischerweise 15 bis 25.

Reflektorstrukturen, die erfindungsgemäß geeignet sind für die Anwendung in Transpondern (siehe Figuren 6d und e), sind periodisch (Periode = pitch) und bestehen aus Elektrodenfingern 31, Zwischenräumen 32, und elektrischen Verbindungen zwischen den Fingern und arbeiten auf der 2. Harmonischen. Die Breite w der Finger ist bevorzugt ungefähr gleich der halben Periode, w=2*λ/4, wobei λ die Wellenlänge bei der Arbeitsfrequenz ν ist, z.B. ν = 2,45 GHz.

In einer bevorzugten Ausführung werden die 2. harmonischen Reflektoren auf 128°-LiNbO$_3$ Substratmaterial realisiert bei einer Metallschichtdicke von ungefähr 800 Angström.

Fig. 6d) beschreibt eine bevorzugte Ausführungsform eines 2. harmonischen Reflektors mit sechs Elektrodenfingern und fünf Zwischenräumen 32. Die Anzahl der Elektrodenfinger ist variabel und kann minimal 1 und maximal ca. 50 betragen. Die Breite der Elektrodenfinger z.B. 31.1, ist bevorzugt ungefähr gleich der Breite der Zwischenräume 32. Die Breite w der Elektrodenfinger auf 128°-LiNbO$_3$ ist ca. w = 2* λ/4 = 0,78 µm, wobei λ die Wellenlänge des SAW-Signals bei der Arbeitsfrequenz von 2,45 GHz ist. Über eine Verbindung am oberen 33.1 und unteren Fingerende 33.2 sind alle Elektrodenfinger elektrisch miteinander verbunden. Die Breite der Verbindung ist bevorzugt ca. 10 µm, sie kann aber auch größer oder noch kleiner gewählt werden. Die bevorzugte Breite des Reflektors, bzw. die Länge der Elektrodenfinger liegt zwischen ungefähr 150 bis 200 µm aber auch andere Werte sind möglich.

Die Reflektivität R (in dB) dieses Reflektors bei der Mittenfrequenz berechnet sich aus R(in dB) = 20* log(tanhyp(N*r)), wobei n die Anzahl der Elektrodenfinger und r der Reflexionskoeffizient des Einzelfingers ist. Im Vergleich zu 3. harmonischen Reflektoren auf 128°-LiNbO$_3$-Substratmaterial, 800 Angstrom Metallschichtdicke und N = 12 Fingern ergibt sich bei 2. harmonischen Reflektoren eine um ca. 6 dB höhere Reflektivität.

Fig. 6e beschreibt eine erfindungsgemäße Ausführungsform eines 2. harmonischen Reflektors, mit einer anderen Art der Verbindung der Elektrodenfinger. Jeweils zwei Finger, z.B. 31.1 und 31.2 werden zu einem Zweierpaar 34 verbunden. Die Breite der Zwischenräume 32 und der Elektrodenfinger ist umgefähr gleich. Die Breite der Verbindung (35.1 und 35.2) ist unkritisch, bevorzugt wird ca. 10 µm, sie kann aber auch größer oder noch kleiner gewählt werden. Weitere Formen der Verbindung der Elektrodenfinger sind möglich.

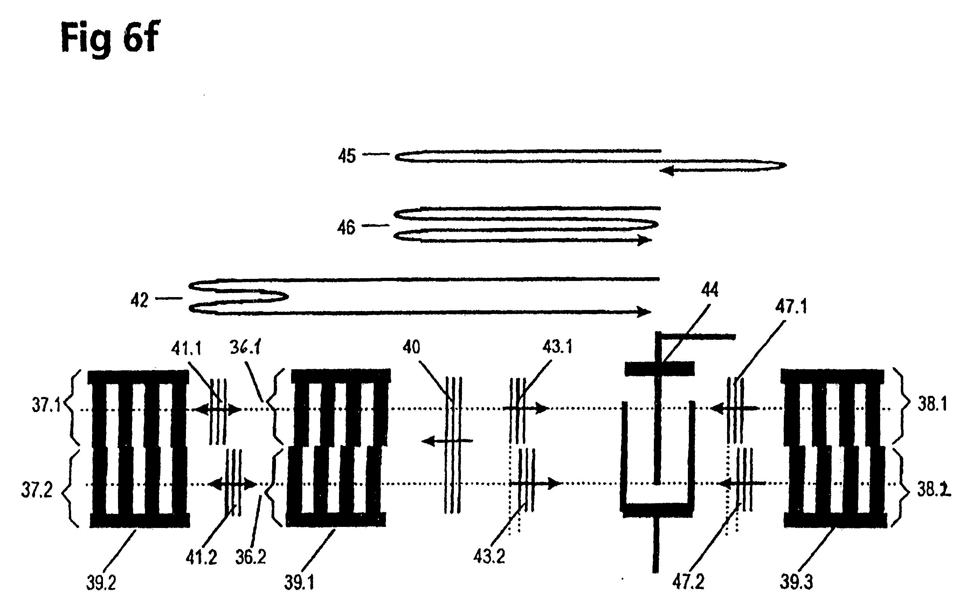

Figur 6f zeigt eine bevorzugte Anordnung von 3 Offset-Reflektoren 39.1, 39.2, 39.3.

Ein wesentliches Merkmal der Offset-Reflektoren ist, daß sie wie in Fig. 6f dargestellt in zwei ungefähr gleiche Hälften 36.1 und 36.2, 37.1 und 37.2, 38.1 und 38.2 zerlegt werden, wobei die eine Hälfte 36.2, 37.2, 38.2 leicht gegen die entsprechend andere Hälfte 36.1, 37.1, 38.1 verschoben wird. Der Betrag der Verschiebung ist von der Größe eines Bruchteils der Wellenlänge λ. Bei der Wahl des Betrages der Verschiebung ist zu beachten, daß bei ungünstiger Wahl die Reflektivität des Offset-Reflektors für die Nutzsignale stark abnehmen kann, obwohl beide Hälften isoliert betrachtet eine hohe Reflektivität aufweisen. Der Betrag der Verschiebung wie auch deren Richtung kann für verschiedene Offset-Reflektoren innerhalb des gleichen Layouts unterschiedlich sein. Die richtige Kombination dieser beiden Einflußgrößen ist ein besonders wichtiges Merkmal.

Ein einfallendes SAW-Signal 40 wird durch den Offset-Reflektor 39.1 in zwei Signalteile 41.1 und 41.2 zerlegt. Ein Teil des einfallenden Signals 40 wird von jeder Hälfte reflektiert und ergibt ein erstes Nutzsignal, ein anderer Teil wird transmittiert und am nachfolgenden Reflektor 39.2 reflektiert. Von dem am Reflektor 39.2 reflektierten Signal wird beim Reflektor 39.1 wiederum ein Teil reflektiert und führt zu einer störenden Mehrfachreflexion; der andere Teil wird transmittiert und ergibt ein zweites Nutzsignal.

In der vorliegenden Anordnung durchlaufen die beiden transmittierten Signalteile 41.1 und 41.2 bis zum Reflektor 39.2 unterschiedlich lange Strecken. Der Wegunterschied ist erfindungsgemäß so gewählt, daß bei der einfachen round-trip-Reflexion 42 (Transmission durch 39.1-Reflexion an 39.2-Reflexion an 39.1-Reflexion an 33.2-Transmission durch 39.1) ein Gangunterschied von ca. $\lambda/2$ zwischen den zurücklaufenden Teilsignalen 43.1 und 43.2 entsteht. Treffen die beiden Teilsignale auf den Transducer 44, so entspricht der Gangunterschied einer 180° Phasenverschiebung der beiden gleichzeitig auftreffenden SAW-Teilsignale. Dies führt zu einer starken Dämpfung der elektrischen Erregung des Transducers 44 und damit zu einer starken Dämpfung des über die Transponderantenne 10 abgestrahlten einfachen round-trip-(Umlauf)-Störsignals.

In der vorliegenden Anordnung kann zusätzlich eine wirkungsvolle Dämpfung für die störenden Mehrfachreflexionen 45 und 46 erzielt werden. 45 entsteht dabei durch die Reflexion an 39.1, Transmission durch 44, Reflexion an 39.3 und 46 entsteht durch die Reflexion an 39.1, Reflexion an 44, Reflexion an 39.1. Die Bedingung für eine wirkungsvolle Dämpfung ist, daß die durch die Offset-Reflektoren erzeugten Teilsignale, z.B. 47.1 und 47.2 der Mehrfachreflexion 45, einen Gangunterschied von ca. $\lambda/2$ aufweisen. Analoges gilt für die Mehrfachreflexion 46. Die elektrische Erregung am Transducer 44 wird durch die zwei gleichzeitig eintreffenden aber entsprechend dem Gangunterschied von $\lambda/2$ um 180° Phasen verschobenen Teilsignale der Mehrfachreflexionen 45 und 46 stark gedämpft.

Wie oben erwähnt, beschreibt Fig. 6f eine bevorzugte Anordnung von 3 Offset-Reflektoren, wobei die Offset-Reflektoren 39.1, 39.2, 39.3 jeweils aus 2. harmonischen Reflektoren entstehen. Die drei Reflektoren sind in je zwei Hälften unterteilt, z.B. Reflektor 39.1 in 36.1 und 36.2. Die untere Hälfte 36.2 des Reflektors 39.1 ist um den Betrag $\Delta 1$, die untere Hälfte 37.2 des Reflektors 39.2 um den Betrag $\Delta 2$ und die untere Hälfte 38.2 des Reflektors 39.3 um den Betrag $\Delta 3$ verschoben. Die Verschiebungen $\Delta 1$, $\Delta 2$ und $\Delta 3$ können unterschiedliche Beträge und Verschiebungsrichtungen annehmen.

Bevorzugt ist die Verschiebungsrichtung für die Hälfte 36.2 und 37.2 nicht gleich, sondern entgegengesetzt. Der Betrag der Verschiebung ist ebenfalls nicht gleich für den Teil 36.2 und 37.2.

Erfindungsgemäß gelten für die Verschiebungen $\Delta 1$, $\Delta 2$ und $\Delta 3$ die folgenden Bedingungen, die wahlweise zusammen oder nur einzeln erfüllt sein können:

$$|4*\Delta 2 - 2*\Delta 1| = \lambda/2 \qquad (A)$$

$$|4*\Delta 1| = \lambda/2 \qquad (B)$$

$$|2*\Delta 1-2*\Delta 3| = \lambda/2 \qquad (C)$$

Verabredungsgemäß werden Verschiebungen in Richtung des unreflektiert einfallenden SAW-Signals 40 positiv solche entgegen dieser Richtung negativ gezählt. Die in den Gleichungen (A - C) angegebenen Bedingungen entsprechen dem Idealfall für einen exakten Wegunterschied von $\lambda/2$. Aber auch bei einer Abweichung bis zu ca. 10 % von $\lambda/2$ ergibt sich noch eine vorteilhafte Dämpfung der Störreflexionen.

Es können noch weitere Bedingungen formuliert werden, die sind aber für die Anwendung in Transpondern meist von geringer Bedeutung.

Eine besonders günstige Lösung der Gleichungen (A - C) ergibt sich bei der folgenden Wahl der Verschiebungen:

$$\Delta 1 = \lambda/8$$

$$\Delta 2 = -\lambda/16$$

$$\Delta 3 = -\lambda/8$$

In der obigen Ausführung erfolgt die Verschiebung also so, daß der Teil 36.2 wird um $\lambda/8$ ($\Delta 1 = \lambda/8$) in Richtung des einfallenden SAW-Signals 40 verschoben und der Teil 37.2 um $\lambda/16$ ($\Delta 2 = -\lambda/16$) entgegen dieser Richtung verschoben wird. Für die einfache round-trip-Reflexion ergibt sich gemäß der Gleichung (A) ein Gangunterschied der beiden Teilsignale um $\lambda/2$.

Durch die Wahl von $\Delta 1 = \lambda/8$ wird zusätzlich die Mehrfachreflexion 46 und durch die Wahl von $\Delta 3 = -\lambda/8$ auch die Mehrfachreflexion 45 stark gedämpft.

Als Folge der erfindungsgemäßen Anordnung kann eine zusätzliche Dämpfung von ungefähr 10 dB für die Störreflexionen erreicht werden.

Für die Realisierung des Transducers 44 existieren eine Vielzahl von bekannten Möglichkeiten. Bei einer Arbeitsfrequenz von 2.45 GHz ist eine bevorzugte Variante die Verwendung eines interdigital-üs Transducers mit aufgetrennten Elektrodenfinger, der auf der 3. Harmonischen arbeitet. Für $128°$-$LiNbO_3$-Substratmaterial ergibt sich eine vorteilhafte Ausführung mit ungefähr 25 aufgetrennten Elektrodenfinger und einer Länge der Finger von ca. 150 $\mu$m bis 200 $\mu$m. Die Transducerimpedanz ist unter diesen Umständen ungefähr 50 Ohm und eine zusätzliche Anpassung ist nicht erforderlich.

Die verschiedenen Ausführungsformen können untereinander kombiniert bzw. abgewandelt werden. Die verschiedenen Arten, die akustischen Kanäle zu koppeln, können im Prinzip kombiniert werden. Akustische Kanäle können parallel und seriell geschaltet sein. Die Anordnung der verschiedenen Kanäle ist vorzugsweise im Sinn minimaler Verluste, eines minimalen Flächenbedarfs und minimaler interner Störreflexe gewählt.

**Patentansprüche**

1. SAW-Element (54) mit einem piezoelektrischen Substrat, wobei mindestens ein interdigitaler Transducer (IDT) zum Einlaufenlassen einer akustischen Oberflächenwelle in einen akustischen Kanal in einer ersten Richtung auf der Oberfläche des Substrats angeordnet ist, und ein Reflektor auf derselben Oberfläche im Inneren des Kanals angeordnet und derart orientiert ist, daß er die akustische Oberflächenwelle in eine zweite Richtung, entgegengesetzt zu der ersten Richtung reflektiert, **dadurch gekennzeichnet, daß** der Reflektor quer, vorzugsweise senkrecht zu dem akustischen Kanal in mindestens zwei Bereiche, die je einen Unterkanal aufspannen, unterteilt, und mindestens ein Bereich in Richtung des akustischen Kanals mit einem Versatz angeordnet ist.

2. SAW-Element (54) nach Anspruch 1, wobei der Versatz ungefähr $\lambda/8$ ist, und wobei $\lambda$ die Wellenlänge ist, die von dem interdigitalen Transducer (IDT) bei der mittigen Betriebsfrequenz des SAW-Elements erzeugt wird.

3. SAW-Element (54) nach Anspruch 1 oder 2, wobei die Bereiche um die entsprechenden Unterkanäle gleiche Aperturen haben.

4. SAW-Element (54) nach Anspruch 1, 2 oder 3, wobei ein zweifach reflektiertes Echosignal wegen des zusätzlichen akustischen Weges $|\lambda/8*4| = \lambda/2$ und der entsprechenden Phasenverschiebung von 180 ° zwischen den Wellen in dem Unterkanal, in dem die Bereiche des Reflektors mit Versatz angeordnet sind, kompensiert wird.

5. SAW-Element (54) nach einem der Ansprüche 1 bis 4, wobei der Reflektor als Kalibrierungsreflektor verwendet wird.

6. SAW-Element (54) nach einem der Ansprüche 1 bis 5, wobei der Transducer bidirektional ist und in der Lage ist, die akustischen Oberflächenwellen mit gleichen Amplituden in gegenüberliegende Richtungen auszusenden.

7. SAW-Element (54) nach Anspruch 6, wobei mindestens ein weiterer Reflektor in dem akustischen Kanal auf der dem Transducer gegenüberliegenden Seite angeordnet ist, wobei der Reflektor quer, vorzugsweise senkrecht zum akustischen Kanal in mindestens zwei Bereiche, die je einen Unterkanal aufspannen, unterteilt und mindestens ein Bereich parallel zum akustischen Kanal mit einem Versatz angeordnet ist.

8. SAW-Element (54) nach Anspruch 6 oder 7, wobei die an gegenüberliegenden Seiten des interdigitalen Transducers angeordneten Reflektoren in Querrichtung in zwei Bereiche mit gleichen Aperturen unterteilt sind, und einer dieser Bereiche in Richtung des IDT oder von dem IDT weg einen Versatz aufweist, der gleich $\lambda/8$ ist, wobei $\lambda$ die Wellenlänge ist, die von dem IDT bei der mittigen Betriebsfrequenz des SAW-Elements erzeugt wird.

9. SAW-Element (54) nach Anspruch 8, wobei das durch einmalige Reflexion an zwei beidseits des Transducers liegenden Reflektoren entstehende Umlaufechosignal wegen der 180 ° Phasenverschiebung zwischen den sich in den beiden Unterkanälen ausbreitenden akustischen Oberflächenwellen gedämpft wird.

10. SAW-Element nach einem der Ansprüche 1 bis 9, wobei ein zweiter Reflektor (39.2) in dem akustischen Kanal in einer größeren Entfernung von dem IDT angeordnet ist als der erste Reflektor, wobei beide Reflektoren in zwei Bereiche mit gleicher Apertur unterteilt sind, und der obere oder untere Bereich des ersten Reflektors (39.1) um den Abstand $|\Delta 1|$ entlang dem akustischen Kanal vom Transducer weg (+x Richtung: Versatz $\Delta 1 = + |\Delta 1|$ ) oder darauf zu (-x Richtung: Versatz $\Delta 1 = -|\Delta 1|$ ) versetzt ist, während der entsprechende Bereich des zweiten Reflektors (39.2) um den Abstand $|\Delta 2|$ versetzt ist.

11. SAW-Element nach Anspruch 10, wobei der Versatz $\Delta 1 = |\Delta 1| = \lambda/8$ und $\Delta 2 = - |\Delta 2| = -\lambda/16$.

12. SWA-Element nach einem der Ansprüche 1 bis 11, das zusätzliche Reflektoren enthält, wobei mindestens einer von den zusätzlichen Reflektoren keinen Versatz zwischen den Bereichen aufweist.

13. SAW-Element nach einem der Ansprüche 1 bis 12, wobei die Reflektoren als kurzgeschlossene, offene, gruppiert verbundene Elektroden aus einem Metall, vorzugsweise aus Al oder Au, gebildet werden, die periodisch mit Periodenabständen von $\lambda/2$, $\lambda$, oder Vielfachen von $\lambda/2$ angeordnet sind, wobei kurzgeschlossene Elektroden zusätzliche Verbindungen aufweisen können.

14. SAW-Element nach einem der Ansprüche 1 bis 13, wobei mehrere Transducer vorgesehen sind, die in verschiedenen akustischen Kanälen angeordnet und miteinander elektrisch verbunden sind.

15. SAW-Element nach einem der Ansprüche 1 bis 14, wobei die Wandler und/oder Reflektoren gewichtet sind, vorzugsweise durch die Elektrodenzahl oder die Öffnungsgröße.

16. SAW-Element nach einem der Ansprüche 1 bis 15, wobei die Reflektoren zum Codieren von Tag-Daten ausgebildet sind, vorzugsweise durch Ihre Zeitlage bzw. den Zeitverzögerungswert der reflektierten Antwort.

17. SAW-Element nach Anspruch 16, wobei für alle Reflektoren eine Anfangsverzögerung $T_{init}$ vorgesehen ist, und alle Reflektoren in einem Abstand von dem entsprechenden IDT angeordnet sind, der größer ist als ein vorgegebener Minimalwert $L_{init} = 2 \times T_{init} / v_{SAW}$, wobei $v_{SAW}$ die Geschwindigkeit der Oberflächenwelle ist.

18. SAW-Element nach Anspruch 17, wobei in einer Mehrzahl der durch die Transducer gebildeten akustischen Kanäle ein oder mehrere Reflektoren mit einer Durchlässigkeit von mehr als 10 % gesetzt sind, und die Reflektoren Antwortsignale mit der exakt gleichen Verzögerung erzeugen.

19. SAW-Element (54) nach einem der Ansprüche 1 bis 18, wobei am Ende eines akustischen Kanals und nahe an der Kante des piezoelektrischen Substrats eine zusätzliche Einrichtung zum Verhindern parasitärer Rückwärtsreflektionen des SAW-Elements durch die Substratkante vorgesehen ist, vorzugsweise durch Absorbieren, Streuen oder Schrägreflexion der Welle.

**Claims**

1. SAW element (54) with a piezoelectric substrate, wherein at least one interdigital transducer (IDT) for feeding a surface acoustic wave in a first direction into an acoustic channel is arranged on the surface of the substrate and a reflector is arranged on the same surface in the interior of the channel and is oriented such that it reflects the surface acoustic wave in a second direction opposite to the first direction, **characterized in that** the reflector is divided transversely, preferably perpendicular to the acoustic channel, into at least two areas which each open up a subchannel, and at least one area is offset with respect to the direction of the acoustic channel.

2. SAW element (54) according to claim 1, wherein the offset is about $\lambda/8$, and wherein $\lambda$ is the wavelength generated by the interdigital transducer (IDT) at the center operating frequency of the SAW element.

3. SAW element (54) according to claim 1 or 2, wherein the areas surrounding the corresponding subchannels have equal apertures.

4. SAW element (54) according to claim 1, 2 or 3, wherein a double reflected echo signal is compensated due to the additional acoustic path $|\lambda/8*4| = \lambda/2$ and the corresponding phase shift of 180° between the waves in the subchannel in which the areas of the reflector are offset.

5. SAW element (54) according any one of claims 1 to 4, wherein the reflector is used as a calibration reflector.

6. SAW element (54) according to any one of claims 1 to 5, wherein the transducer is bidirectional and is able to emit the surface acoustic waves with the same amplitudes in opposite directions.

7. SAW element (54) according to claim 6, wherein at least one further reflector is arranged in the acoustic channel at the side opposite to the transducer, wherein the reflector is divided transversely, preferably perpendicular to the acoustic channel, into at least two areas which each open up a subchannel, and at least one area is offset and arranged parallel with respect to the direction of the acoustic channel.

8. SAW element (54) according to claim 6 or 7, wherein the reflectors arranged on opposing surfaces of the interdigital transducer are divided in the transverse direction into two areas having equal apertures and one of said areas has an offset in the direction of the IDT or away from the IDT, said offset being $\lambda/8$, wherein $\lambda$ is the wavelength generated by the IDT at the center operating frequency of the SAW element.

9. SAW element (54) according to claim 8, wherein the round-trip echo signal generated by one single reflection on two reflectors arranged on both sides of the transducer is attenuated due to the 180° phase shift between the surface acoustic waves propagating in the two subchannels.

10. SAW element according to any one of claims 1 to 9, wherein a second reflector (39.2) is arranged in the acoustic channel at a greater distance from the IDT than the first reflector, wherein both reflectors are divided into two areas having an equal aperture and the upper or the lower area of the first reflector (39.1) is offset by the distance $|\Delta 1|$ along the acoustic channel away from the transducer (+x direction: offset $\Delta 1 = + |\Delta 1|$) or towards the transducer (-x direction: offset $\Delta 1 = -|\Delta 1|$), while the corresponding

area of the second reflector (39.2) is offset by the distance |Δ2|.

11. SAW element according to claim 10, wherein the offset Δ1 = |Δ1| = λ/8 and Δ2 = -|Δ2| = -λ/16.

12. SAW element according to any one of claims 1 to 11 which comprises additional reflectors, wherein at least one of said additional reflectors does not comprise an offset between the areas.

13. SAW element according to any one of claims 1 to 12, wherein the reflectors are formed as short-circuited, open electrodes connected in groups and made of a metal, preferably Al or Au, and being arranged periodically with periodic distances of λ/2, λ or multiples of λ/2, wherein short-circuited electrodes may comprise additional connections.

14. SAW element according to any one of claims 1 to 13, wherein a plurality of transducers are provided which are arranged in different acoustic channels and are electrically connected with each other.

15. SAW element according to any one of claims 1 to 14, wherein the transducers and/or reflectors are weighted, preferably by the number of electrodes or the size of the aperture.

16. SAW element according to any one of claims 1 to 15, wherein the reflectors are suited for encoding tag data, preferably due to their position in time or the time delay value of the reflected response.

17. SAW element according to claim 16, wherein all reflectors have an initial delay $T_{init}$ and all reflectors are arranged at a distance from the corresponding IDT which is greater than a predetermined minimum value $L_{init} = 2 \times T_{init}/v_{SAW}$, wherein $v_{SAW}$ is the velocity of the surface wave.

18. SAW element according to claim 17, wherein in a plurality of the acoustic channels formed by the transducers one reflector or a plurality of reflectors having a transmittance of more than 10% is/are placed and the reflectors generate response signals having exactly the same delay.

19. SAW element (54) according to any one of claims 1 to 18, wherein at the end of an acoustic channel and close to the edge of the piezoelectric substrate an additional means is provided for preventing parasitic reverse reflections of the SAW element through the edge of the substrate, preferably by absorption, scattering or inclined reflection of the wave.

**Revendications**

1. Elément à ondes acoustiques de surface (54) muni d'un substrat piézo-électrique, dans lequel au moins un transducteur interdigital (IDT) est disposé en vue de l'introduction par écoulement d'une onde acoustique de surface dans un canal acoustique dans une première direction à la surface du substrat, et un réflecteur est disposé sur la même surface à l'intérieur du canal et est orienté de sorte qu'il réfléchit l'onde acoustique de surface dans une seconde direction, opposée à la première direction, **caractérisé en ce que** le réflecteur est divisé transversalement, de préférence verticalement au canal acoustique en au moins deux zones, qui fixent chacune un sous-canal, et au moins une zone est disposée dans la direction du canal acoustique avec un décalage.

2. Elément à ondes acoustiques dé surface (54) selon la revendication 1, dans lequel le décalage est d'environ λ/8, et dans lequel λ est la longueur d'onde, qui est produite par le transducteur interdigital (IDT) lors de la fréquence de service centrale de l'élément à ondes acoustiques de surface.

3. Elément à ondes acoustiques de surface (54) selon la revendication 1 ou 2, dans lequel les zones autour des sous-canaux correspondants présentent les mêmes ouvertures.

4. Elément à ondes acoustiques de surface (54) selon la revendication 1, 2 ou 3, dans lequel est compensé un signal d'écho réfléchi deux fois à cause du trajet acoustique supplémentaire |λ/8*4| = λ/2 du déphasage de 180° correspondant entre les ondes dans le sous-canal, dans lequel les zones du réflecteur sont disposées avec un décalage.

5. Elément à ondes acoustiques de surface (54) selon l'une des revendications 1 à 4, dans lequel le réflecteur est utilisé en tant que réflecteur de calibrage.

6. Elément à ondes acoustiques de surface (54) selon l'une des revendications 1 à 5, dans lequel le transducteur est bidirectionnel et peut rayonner les ondes acoustiques de surfaces avec la même amplitude dans des directions opposées.

7. Elément à ondes acoustiques de surface (54) selon la revendication 6, dans lequel au moins un autre réflecteur est disposé dans le canal acoustique sur le côté en vis-à-vis du transducteur, dans lequel le réflecteur est divisé transversalement, de préférence verticalement au canal acoustique en au moins deux zones, qui fixent chacune un sous-canal, et au moins une zone est disposée parallèle au canal acoustique avec un décalage.

**8.** Elément à ondes acoustiques de surface (54) selon la revendication 6 ou 7, dans lequel les réflecteurs disposés sur les côtés en vis-à-vis du transducteur interdigital sont divisés dans une direction transversale en deux zones avec les mêmes ouvertures, et une de ces zones présente un décalage dans la direction de l'IDT ou s'éloignant de l'IDT, qui est égale à $\lambda/8$, où $\lambda$ est la longueur d'onde, qui est produite par l'IDT lors de la fréquence de service central de l'élément à ondes acoustiques de surface.

**9.** Elément à ondes acoustiques de surface (54) selon la revendication 8, dans lequel le signal d'écho rotatif provenant de la réflexion unique sur les deux réflecteurs se trouvant sur les deux côtés du transducteur est atténué à cause du déphasage de 180° entre les ondes acoustiques de surface se propageant dans les deux sous-canaux.

**10.** Elément à ondes acoustiques de surface (54) selon l'une des revendications 1 à 9, dans lequel un second réflecteur (39.2) est disposé dans le canal acoustique à une plus grande distance de l'IDT que le premier réflecteur, dans lequel les deux réflecteurs sont divisés en deux zones avec la même ouverture, et la zone supérieure ou inférieure du premier réflecteur (39.1) est décalée d'une distance $|\Delta 1|$ le long du canal acoustique en s'éloignant du transducteur (direction +x : décalage $\Delta 1 = + |\Delta 1|$) ou en s'en rapprochant (direction -x : décalage $\Delta 1 = -|\Delta 1|$), tandis que la zone correspondante du second réflecteur (39.2) est décalée d'une distance $|\Delta 2|$.

**11.** Elément à ondes acoustiques de surface selon la revendication 10, dans lequel le décalage $\Delta 1 = |\Delta 1| = \lambda/8$ et $\Delta 2 = -|\Delta 2| = -\lambda/16$.

**12.** Elément à ondes acoustiques de surface selon l'une des revendications 1 à 11, qui contient des réflecteurs supplémentaires, dans lequel au moins un des réflecteurs supplémentaires ne présente de décalage entre les zones.

**13.** Elément à ondes acoustiques de surface selon l'une des revendications 1 à 12, dans lequel les réflecteurs sont formés en tant qu'électrodes connectées groupées, ouvertes, court-circuitées en métal, de préférence en Al ou Au, qui sont disposées périodiquement avec des distances de période de $\lambda/2$, $\lambda$ ou des multiples de $\lambda/2$, dans lequel des électrodes court-circuitées peuvent présenter des liaisons supplémentaires.

**14.** Elément à ondes acoustiques de surface selon l'une des revendications 1 à 13, dans lequel plusieurs transducteurs sont prévus, qui sont disposés dans des canaux acoustiques différents et reliés électriquement les uns avec les autres.

**15.** Elément à ondes acoustiques de surface selon l'une des revendications 1 à 14, dans lequel les convertisseurs et/ou réflecteurs sont pondérés, de préférence par le nombre d'électrodes ou par la dimension de l'ouverture.

**16.** Elément à ondes acoustiques de surface selon l'une des revendications 1 à 15, dans lequel les réflecteurs sont réalisés pour le codage de jour-date, de préférence par leur intervalle de temps ou la valeur de retard de temps de la réponse réfléchie.

**17.** Elément à ondes acoustiques de surface selon la revendication 16, dans lequel, pour tous les réflecteurs, un retard de début $T_{init}$ est prévu, et tous les réflecteurs sont disposés à une distance de l'IDT correspondant, qui est supérieure à une valeur minimale prédéterminée $L_{init} = 2 \times T_{init}/v_{SAW}$, où $v_{SAW}$ est la vitesse de l'onde de surface.

**18.** Elément à ondes acoustiques de surface selon la revendication 17, dans lequel dans une pluralité de canaux acoustiques formés par le transducteur, un ou plusieurs réflecteurs sont disposés avec une perméabilité de plus de 10%, et les réflecteurs produisent des signaux de réponse avec exactement le même retard.

**19.** Elément à ondes acoustiques de surface (54) selon l'une des revendications 1 à 18, dans lequel à l'extrémité d'un canal acoustique et près du bord du substrat piézo-électrique, un dispositif supplémentaire est prévu en vue d'empêcher des réflexions en sens inverse parasites de l'élément à ondes acoustiques de surface à travers le bord du substrat, de préférence par absorption, dispersion ou réflexion oblique de l'onde.

# Fig. 1

EP 1 035 419 B1

# Fig. 2a

# Fig. 2b

Laufzeit der Antwortsignale

# Fig. 3

**Column 1:**

Antwortsignal speichern (Zeitsignal)

↓

Gewichtung mit Fensterfunktion

↓

FFT des Zeitsignals --> Spektrum

↓

Suchen der Position des kalibrierenden Stützwertes im Spektrum --> $\Delta\omega$

↓

Multiplikation des Zeitsignals mit $\exp(-j\Delta\omega t)$ --> kalibriertes Zeitsignal

↓

Gewichtung mit Fensterfunktion

↓

FFT des kalibrierten Zeitsignals

↓

Suche der lokalen maximalen Stützwerte innerhalb von jedem Frequenzfenster bis max. k Frequenzschlitze.

**Column 2:**

Bestimmung des Geräuschwertes N

↓

Signal/N >= Schwelle — nein → Fehler

↓ ja

Code Teil 1 speichern

↓

Schätzung des Gradienten der Temperaturverschiebung im Code Teil 1

↓

Bestimmung der Frequenzverschiebung des letzten (k.) Frequenzfensters von Code Teil 1 --> $\delta\Delta\omega$

↓

Multiplikation des kalibrierten Zeitsignals mit $\exp(-j\delta\Delta\omega t)$

↓

Gewichtung mit Fensterfunktion

**Column 3:**

FFT des korrigierten und kalibrierten Zeitsignals

↓

Suche der lokalen maximalen Stützwerte innerhalb von jedem Frequenzfenster oberhalb Code Teil 1 bis max. 2 k Frequenzschlitze.

↓

Signal/N >= Schwelle — nein → Fehler

↓ ja

Code Teil 2 speichern

⋮

etc.

EP 1 035 419 B1

Fig. 4

EP 1 035 419 B1

# Fig. 5

EP 1 035 419 B1

# Fig. 6a

10 24 18 14 25

14.1

11

23.1 11.1 27 12.1 26.1

23.2 11.2 26.2

23.3 11.3 26.3

EP 1 035 419 B1

Fig. 6b

# Fig. 6c

EP 1 035 419 B1

# Fig 6d

33.1

32

31.1

31.2

33.2

# Fig 6e

34

35.1

32

31.1

31.2

35.2

EP 1 035 419 B1

# Fig 6f